# EUROPEAN PATENT APPLICATION

(11) **EP 4 797 719 A1**
(43) Date of publication of application: **26.08.2026**
(21) Application number: 24887706.0
(22) Date of filing: 14.10.2024
(51) Int. Cl.: H04Q 11/00

(54) **MODEL ESTABLISHMENT METHOD FOR OPTICAL CABLE PATH, ACQUISITION METHOD AND APPARATUS, AND COMPUTING DEVICE**

(30) Priority: 09.11.2023 CN 202311505163
(71) Applicant: HUAWEI TECHNOLOGIES CO., LTD., Shenzhen 518129 (CN)
(72) Inventor: CHEN, Jiabao, Shenzhen, Guangdong 518129 (CN); ZHANG, Bigui, Shenzhen, Guangdong 518129 (CN); ZHAO, Kaidi, Shenzhen, Guangdong 518129 (CN); LIU, Xiaochun, Shenzhen, Guangdong 518129 (CN); CHEN, Zhirui, Shenzhen, Guangdong 518129 (CN)
(74) Representative: Thun, Clemens
(86) International application number: PCT/CN2024/124669
(87) International publication number: WO 2025/098093

(57) **Abstract**

This application discloses a model establishment method and a model obtaining method for an optical cable path, an apparatus, and a computing device, relating to the field of communication technologies. In this method, a routing hop of an optical cable on each optical cable routing node that the optical cable passes through can be determined based on a splicing tray image of the optical cable routing node; and a digital twin model of an optical cable path of the optical cable is established based on each routing hop of the optical cable and a connection status between each optical cable segment and the optical cable routing node, to perform 1:1 digital restoration on a physical topology of the optical cable path by using the digital twin model, so that digital management is subsequently performed on dumb optical line resources on the optical cable path by using the digital twin model.

## Description

This application claims priority to Chinese Patent Application No. 202311505163.0, filed on November 9, 2023 and entitled "MODEL ESTABLISHMENT METHOD AND MODEL OBTAINING METHOD FOR OPTICAL CABLE PATH, APPARATUS, AND COMPUTING DEVICE", which is incorporated herein by reference in its entirety.

### TECHNICAL FIELD

This application relates to the field of communication technologies, and in particular, to a model establishment method and a model obtaining method for an optical cable path, an apparatus, and a computing device.

### BACKGROUND

A large quantity of dumb optical line resources are disposed in an area in which an optical fiber communication network is located to provide services for optical fiber communication. The dumb optical line resources refer to passive optical fiber network infrastructures, for example, pipes, poles, optical cables, man-hand holes, optical fiber distribution terminals (briefly referred to as fiber distribution terminals), optical distribution frames (optical distribution frame, ODF), or closures.

Using these dumb optical line resources, optical cable paths are formed by laying optical cables between network element devices in the optical fiber communication network, allowing the network element devices to communicate with each other through the optical cable paths. However, because the dumb optical line resources have weak digital capabilities, a network management system manages the optical cable paths in the optical fiber communication network based on a network topology.

However, the network topology describes logical connection relationships between network devices, and cannot reflect a physical topology of the optical cable paths. This makes it difficult to digitally manage the optical cable paths.

### SUMMARY

Embodiments of this application provide a model establishment method and a model obtaining method for an optical cable path, an apparatus, and a computing device, to establish a digital twin model of an optical cable path, so as to reflect a physical topology of the optical cable path by using the digital twin model. The technical solutions are as follows.

According to a first aspect, a model establishment method for an optical cable path is provided. In the method, first, a splicing tray image of each optical cable routing node that an optical cable passes through is obtained; then, for any optical cable routing node, a routing hop of the optical cable on the optical cable routing node is determined from an end in a splicing tray based on a splicing tray image of the optical cable routing node; and next, an optical cable path of the optical cable is modeled based on routing hops of the optical cable and racking information of all optical cable segments of the optical cable, to obtain a digital twin model of the optical cable path, where the splicing tray image is used to present a splicing tray in the optical cable routing node and an end in the splicing tray, and the racking information indicates a connection status between the optical cable segment and the optical cable routing node.

In this method, the routing hop of the optical cable on each optical cable routing node that the optical cable passes through can be determined based on a splicing tray image of the optical cable routing node; and a digital twin model of an optical cable path of the optical cable is established based on the routing hops of the optical cable and a connection status between all optical cable segments and the optical cable routing node, to perform 1:1 digital restoration on a physical topology of the optical cable path by using the digital twin model, so that digital management is subsequently performed on dumb optical line resources on the optical cable path by using the digital twin model.

In a possible implementation, in the foregoing process of determining, based on the splicing tray image of the optical cable routing node, the routing hop of the optical cable on the optical cable routing node from the end in the splicing tray, for example, first, a splicing tray model of the optical cable routing node is established based on the splicing tray image; and then, the routing hop of the optical cable on the optical cable routing node is determined based on the splicing tray model, where the splicing tray model indicates each splicing tray in the optical cable routing node and each end in the splicing tray.

In a possible implementation, in the foregoing process of determining, based on the splicing tray model, the routing hop of the optical cable on the optical cable routing node, for example, a hop confirmation request is first sent to a terminal based on the splicing tray model, to indicate to confirm the routing hop based on the splicing tray model; then, a hop confirmation response of the terminal is received; and the routing hop is then determined based on the hop confirmation response, where the hop confirmation response indicates to confirm at least one end as the routing hop.

Based on the foregoing possible implementation, the routing hop of the optical cable on the optical cable routing node is confirmed from the terminal based on the splicing tray model, to avoid a case in which the routing hop is confirmed when the routing hop changes.

In a possible implementation, after that the hop confirmation request is sent to the terminal, the method further includes the following step: receiving the racking information that is returned by the terminal based on the splicing tray model.

Based on the foregoing possible implementation, when the racking information of the optical cable segment is obtained from the terminal, the racking information does not need to be queried from a racking information library, and correctness of the obtained racking information can also be ensured.

In a possible implementation, in the foregoing process of modeling the optical cable path of the optical cable based on the routing hops of the optical cable and the racking information of all the optical cable segments of the optical cable, to obtain the digital twin model of the optical cable path, for example, first, a reference optical cable path is determined based on the routing hops of the optical cable and the racking information of all the optical cable segments of the optical cable, where the reference optical cable path includes all optical cable routing nodes that the optical cable passes through; then, path fitting is performed based on the reference optical cable path and a key point on the optical cable path, to obtain a list of dumb optical line resources of the optical cable path, where the dumb optical line resource indicates a dumb optical line resource that the optical cable passes through; and next, the digital twin model is generated based on the list of dumb optical line resources, each routing hop of the optical cable, and the racking information of each optical cable segment of the optical cable.

Based on the foregoing possible implementation, the digital twin model is generated based on the list of dumb optical line resources, the routing hops of the optical cable, and the racking information of all the optical cable segments of the optical cable, so that the digital twin model can describe a routing status of the optical cable and dumb optical cable resources that the optical cable path actually passes through, to perform 1:1 digital restoration on the optical cable path.

According to a second aspect, a model obtaining method for an optical cable path is provided. In the method, first, a splicing tray image of an optical cable routing node that an optical cable passes through is obtained, where the splicing tray image is used to present a splicing tray in the optical cable routing node and an end in the splicing tray; then, the splicing tray image is sent to a server; and next, a digital twin model that is of an optical cable path of the optical cable and that is established based on the splicing tray image is received.

In this method, a digital twin model of an optical cable path of an optical cable is established based on a splicing tray image of each optical cable routing node that the optical cable passes through, to perform 1:1 digital restoration on a physical topology of the optical cable path by using the digital twin model, so that digital management is subsequently performed on dumb optical line resources on the optical cable path by using the digital twin model.

In a possible implementation, after that the splicing tray image is sent to the server, the method further includes the following steps: for example, displaying a splicing tray model of the optical cable routing node; and in response to a hop confirmation operation on at least one end indicated by the splicing tray model, sending a hop confirmation response to the server based on the at least one end and a splicing tray to which the at least one end belongs, where the splicing tray model indicates each splicing tray in the optical cable routing node and each end in the splicing tray, and the hop confirmation response indicates to confirm the at least one end as a routing hop.

Based on the foregoing possible implementation, information about a routing hop of the optical cable on the optical cable routing node can be quickly recorded by operating the splicing tray model, so that the server quickly confirms the routing hop based on the hop confirmation response.

In a possible implementation, after that the splicing tray model of the optical cable routing node is displayed, the method includes the following steps: for example, for an optical cable segment connected to the optical cable routing node in the optical cable, in response to a connection confirmation operation on the at least one end, sending racking information of the optical cable segment to the server based on the at least one end and the splicing tray to which the at least one end belongs, where the racking information indicates a connection status between the optical cable segment and the optical cable routing node, and the connection confirmation operation is used to confirm that an optical fiber in the optical cable segment is connected to a corresponding end.

Based on the foregoing possible implementation, the racking information of the optical cable segment can be quickly recorded by operating the splicing tray model, meaning that quick recording for the racking information is implemented, so that the server obtains the racking information of the optical cable segment.

In a possible implementation, before that the splicing tray image of the optical cable routing node that the optical cable passes through is obtained, the method further includes the following steps: for example, displaying an equipment room model template, where the equipment room model template includes a plurality of cabinet areas, and the cabinet area is used to present one cabinet in an equipment room to which the optical cable routing node belongs; and in response to a cabinet adding operation on any cabinet area, adding a cabinet identifier to the cabinet area, to obtain an equipment room model of the equipment room, where the cabinet identifier indicates a cabinet at a position corresponding to the cabinet area in the equipment room.

According to a third aspect, a model establishment apparatus for an optical cable path is provided. The apparatus is configured to perform the method provided in any one of the first aspect or the optional manners of the first aspect.

According to a fourth aspect, a model obtaining apparatus for an optical cable path is provided. The apparatus is configured to perform the method provided in any one of the second aspect or the optional manners of the second aspect.

According to a fifth aspect, a computing device is provided. The computing device includes a processor, and the processor is configured to execute program code, to enable a computer device to implement the method provided in any one of the first aspect or the optional manners of the first aspect, and/or implement the method provided in any one of the second aspect or the optional manners of the second aspect.

According to a sixth aspect, a computer-readable storage medium is provided. The storage medium stores at least one piece of program code, and the program code is read by a processor, to enable a computing device to perform the method provided in any one of the first aspect or the optional manners of the first aspect, and/or implement the method provided in any one of the second aspect or the optional manners of the second aspect.

According to a seventh aspect, a computer program product or a computer program is provided. The computer program product or the computer program includes program code, the program code is stored in a computer-readable storage medium, a processor reads the program code from the computer-readable storage medium, and the processor executes the program code, to enable a computing device to perform the method provided in any one of the first aspect or the optional implementations of the first aspect, and/or implement the method provided in any one of the second aspect or the optional manners of the second aspect.

Based on the implementations provided in the foregoing aspects, the implementations in this application may be further combined to provide more implementations.

### BRIEF DESCRIPTION OF DRAWINGS

FIG. 1 is a diagram of an application environment of a model establishment method for an optical cable path according to an embodiment of this application;
FIG. 2 is a topology diagram of an optical cable path according to an embodiment of this application;
FIG. 3 is a diagram of a system architecture of a model establishment method for an optical cable path according to an embodiment of this application;
FIG. 4 is a diagram of key information required by a digital base for dumb resources according to an embodiment of this application;
FIG. 5 is a flowchart of a model establishment method for an optical cable path according to an embodiment of this application;
FIG. 6 is a diagram of a path modeling interface according to an embodiment of this application;
FIG. 7 is a timing diagram for entry of dumb optical line resources according to an embodiment of this application;
FIG. 8 is a diagram of an equipment room model template according to an embodiment of this application;
FIG. 9 is a diagram of an equipment room model according to an embodiment of this application;
FIG. 10 is a diagram of obtaining a splicing tray image according to an embodiment of this application;
FIG. 11 is a diagram of a sample image according to an embodiment of this application;
FIG. 12 is a diagram of a splicing tray image according to an embodiment of this application;
FIG. 13 is a diagram of a first splicing tray interface according to an embodiment of this application;
FIG. 14 is a diagram of a second splicing tray interface according to an embodiment of this application;
FIG. 15 is a diagram of a hop information recording interface according to an embodiment of this application;
FIG. 16 is a diagram of a racking information recording interface according to an embodiment of this application;
FIG. 17 is a diagram of an electronic map according to an embodiment of this application;
FIG. 18 is a diagram of a structure of a model establishment apparatus for an optical cable path according to an embodiment of this application;
FIG. 19 is a diagram of a structure of a model obtaining apparatus for an optical cable path according to an embodiment of this application; and
FIG. 20 is a diagram of a structure of a computing device according to an embodiment of this application.

### DESCRIPTION OF EMBODIMENTS

For ease of understanding of specific implementations of this application, the implementations of this application are described with reference to the accompanying drawings.

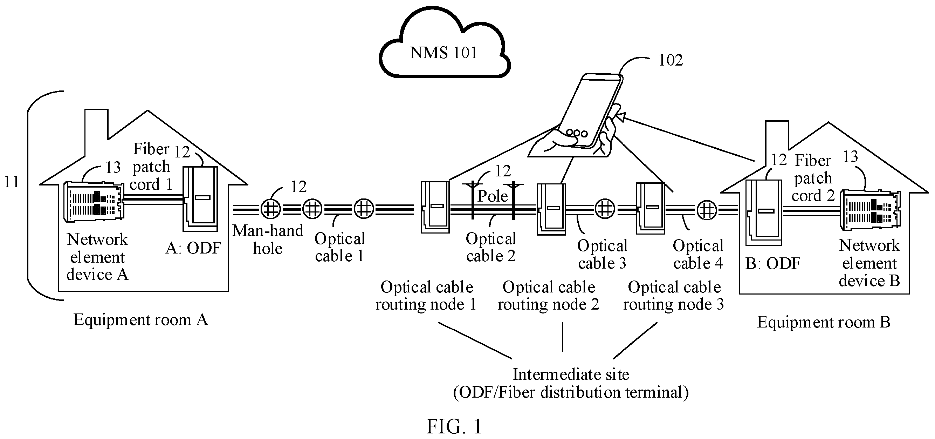

Next, an application environment of a model establishment method for an optical cable path provided in this application is described with reference to FIG. 1.

As shown in FIG. 1, the application environment includes an optical fiber communication network 11. The optical fiber communication network 11 refers to any network in which communication is performed through an optical fiber, for example, a slicing packet network (slicing packet network, SPN). A type of the optical fiber communication network 11 is not limited in embodiments of this application.

A plurality of dumb optical line resources 12, for example, pipes, poles, optical cables, man-hand holes, fiber distribution terminals, ODFs, and closures, are deployed in an area in which the optical fiber communication network 11 is located. The optical fiber communication network 11 includes a plurality of network element devices 13 forming at least one link, each link includes at least two network element devices 13, and two adjacent network devices on a same link communicate with each other through an optical fiber in an optical cable. Two adjacent network element devices are distributed in different equipment rooms. Because a distance between the different equipment rooms is excessively long, and an optical cable segment is not long enough, a plurality of optical cable segments may be spliced and connected (which is referred to as splicing for short) by using dumb optical line resources between the two adjacent network element devices, to form one optical cable, so as to connect network element devices in the different equipment rooms. The optical cable may be set up on a plurality of dumb optical line resources between the two adjacent network element devices, to form an optical cable path, that is, the optical cable path includes the optical cable and the plurality of dumb optical line resources. The dumb optical line resources on the optical cable path are classified into an optical cable routing node and a non-optical cable routing node. The optical cable routing node refers to a dumb optical line resource used for optical cable branching, for example, a fiber distribution terminal and an ODF. As shown in FIG. 1, the ODF is located in an equipment room, and the fiber distribution terminal is independently located outside the equipment room. The non-optical cable routing node refers to a dumb optical line resource other than the optical cable routing node on the optical cable path, for example, a pole, a man-hand hole, or a closure.

The optical cable on the optical cable path includes at least one optical cable segment. When a plurality of optical cable segments are included, two ends of each optical cable segment are respectively spliced to two optical cable routing nodes, and two adjacent optical cable segments are spliced through a same optical cable routing node. In this way, the plurality of optical cable segments are spliced into one optical cable through the optical cable routing nodes. FIG. 1 is used as an example. It is assumed that an optical cable routing node A in an equipment room A is connected to an optical cable routing node B in an equipment room B through one optical cable, the optical cable routing node A is connected to one end of an optical cable 1, and the optical cable 1 is laid on a dumb optical line resource between the optical cable routing node A and an optical cable routing node 1, until the other end of the optical cable 1 is connected to the optical cable routing node 1, to perform optical cable branching on the optical cable 1. For example, the optical cable 1 of 144 cores (that is, optical fibers) is spliced to an optical cable 2 of 72 cores and an optical cable A of 72 cores through the optical cable routing node 1. The optical cable 2 is laid on a dumb optical line resource between the optical cable routing node 1 and an optical cable routing node 2, until the other end of the optical cable 2 is spliced to the optical cable routing node 2. The rest is deduced by analogy, until one end of an optical cable 4 is spliced to an optical cable routing node B. In this way, the optical cable 1, the optical cable 2, an optical cable 3, and the optical cable 4 form an optical cable, and the optical cable and each optical path resource that the optical cable passes through form an optical cable path.

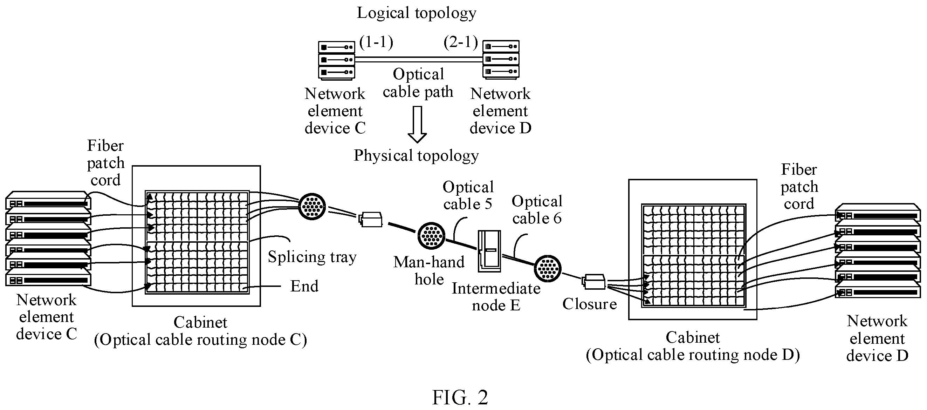

An output port of one network device in any two network element devices and an input port of the other network device are referred to as a port pair, and one port pair between any two network element devices transmits an optical signal through one optical cable path. A topology diagram of an optical cable path shown in FIG. 2 is used as an example. For example, a port of a network element device is referred to as a network element port, a network element port (1-1) of a network element device C and a network element port (2-1) of a network element device D are a port pair, and the port pair is connected through a specific optical cable path. Different port pairs between any two network element devices may transmit optical signals through different optical cable paths, or may transmit optical signals through a same optical cable path. For example, if different port pairs are connected to optical fibers on different optical cable paths, the different port pairs transmit optical signals through different optical cable paths; or if different port pairs are connected to different optical fibers on a same optical cable path, the different port pairs transmit optical signals through a same optical cable path.

For any optical cable path, based on a transmission direction of an optical signal, an optical cable routing node that first receives an optical signal on the optical cable path is referred to as a source routing node, for example, an optical cable routing node A, and an optical cable routing node that last outputs an optical signal on the optical cable path is referred to as a sink routing node, for example, an optical cable routing node B. If an optical cable routing node still exists between the source routing node and the sink routing node on the optical cable path, the optical cable routing node between the source routing node and the sink routing node is referred to as an intermediate node, for example, an optical cable routing node 1 to an optical cable routing node 3. A network element port that transmits an optical signal to the source routing node is referred to as a source of an optical cable/optical cable path, and a network element port that is configured to receive an optical signal output by the sink routing node is referred to as a sink of the optical cable/optical cable path. For example, in FIG. 1, a network element port 1 of the network element device A is a source, and a network element port 2 of the network element device B is a sink. The network element port 1 is spliced to the optical cable routing node A through a fiber patch cord 1, the optical cable routing node A is spliced to an optical fiber in the optical cable 1 through optical cable branching, and the network element port 2 of the network element device B is spliced to the optical fiber in the optical cable 1 through a fiber patch cord 2. In this way, an optical signal output by the network element port 1 is transmitted to the network element port 2 through the fiber patch cord 1, optical fibers in the optical cable 1 to the optical cable 4, and the fiber patch cord 2. Therefore, the optical cable path is an optical signal transmission path between the source and the sink.

As shown in FIG. 2, any optical cable routing node is located in a cabinet, the optical cable routing node includes at least one splicing tray, each splicing tray includes a plurality of ends, each end is configured to splice an optical fiber, the ends in the splicing tray are classified into input ends and output ends, the input end is used to connect to incoming optical fibers (for example, fiber patch cords or optical fibers in an optical cable), and the output end is used to lead out outgoing optical fibers. Optical fiber splicing and optical cable branching may be implemented on the optical cable routing node by using the splicing tray. The optical cable path shown in FIG. 2 is used as an example. It is assumed that the network element port of the network element device C and the network element port of the network element device D are respectively a source and a sink, the network element port of the network element device C is connected to one input end in any splicing tray in an optical cable routing node C through a fiber patch cord, the input end is connected to one output end in the splicing tray or another splicing tray, and the output end is connected to one optical fiber in a specific optical cable segment, so that the network element port may be connected to the optical cable through one fiber patch cord, one input end in the splicing tray, and one output end. A plurality of input ends in the optical cable routing node C are connected to different optical fibers in a same optical cable, to aggregate and connect, to a same optical cable segment, a plurality of fiber patch cords connected to the plurality of input ends. A connection manner between the network element device D and an optical cable routing node D is similar to a connection manner between the network element device C and the optical cable routing node C, and a difference lies in that the network element port of the network element device D is connected to an output end in the optical cable routing node D through a fiber patch cord. For an intermediate node E, it is assumed that 144 input ends in the intermediate routing node E are respectively connected to different optical fibers in an optical cable 5. For 144 output ends connected to the 144 input ends, 72 output ends are connected to 72 optical fibers in an optical cable 6, and 72 output ends are connected to 72 optical fibers in an optical cable 7, so that the optical cable 5 of 144 cores is branched to the optical cable 6 of 72 cores and the optical cable 7 of 72 cores.

In a related technology, a network topology of an optical fiber communication network describes a logical connection relationship between network element devices. A logical topology shown in FIG. 2 is used as an example. The network element port (1-1) and the network element port (2-1) are connected through an optical cable path. However, the logical topology cannot reflect a physical topology of the optical cable path. For example, the logical topology cannot reflect dumb optical line resources that exist on the optical cable path or a connection status of an optical cable on the optical cable path on each optical cable routing node. As a result, it is difficult to perform digital management on the optical cable path.

In view of this, this application provides a model establishment method for an optical cable path. According to the method, a digital twin model of an optical cable path may be established, to perform 1:1 digital restoration on a physical topology of the optical cable path. The method may be applied to a network management system (network management system, NMS) of an optical fiber communication network, so that the NMS establishes a digital twin model of each optical cable path in the optical fiber communication network by using the method, and performs digital management on each optical cable path by using the digital twin model of the optical cable path.

As shown in FIG. 1, the application environment further includes an NMS 101 and a terminal 102. There may be at least one terminal 102. Each terminal 102 may exchange data with the NMS 101. The NMS 101 is responsible for running, management, and maintenance of the optical fiber communication network. The terminal 102 is configured to provide information required for modeling the optical cable path for the NMS 101. The NMS 101 performs, based on the information provided by the terminal 102, the model establishment method for an optical cable path, to establish the digital twin model for the optical cable path.

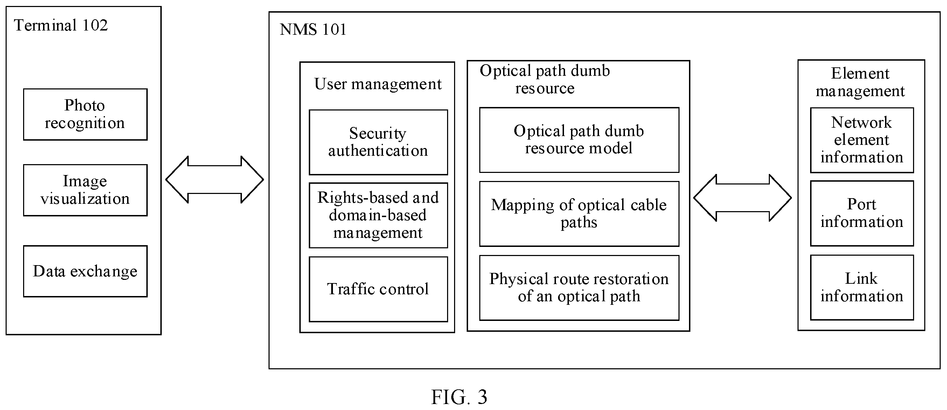

In a diagram of a system architecture shown in FIG. 3, the terminal 102 has a plurality of functions such as photo recognition, image visualization, and data exchange with the NMS 101. The terminal 102 may photograph a real-world image of an optical cable routing node and recognize a splicing tray in the real-world image by using the photo recognition function, visually present content of the optical cable routing node on the terminal by using the image visualization function, and perform data exchange with the NMS 101 by using the data exchange function, for example, may provide the real-world image for the NMS 101. The NMS 101 establishes a digital twin model for the optical cable path based on a real-world image provided by a client, and displays the established digital twin model on the terminal 102 by using an image visualization function of the client.

Still refer to FIG. 3. The NMS 101 includes a user management module, an element management module, and a dumb optical line resource module. The user management module is responsible for user security management, rights-based and domain-based management, traffic control, and the like.

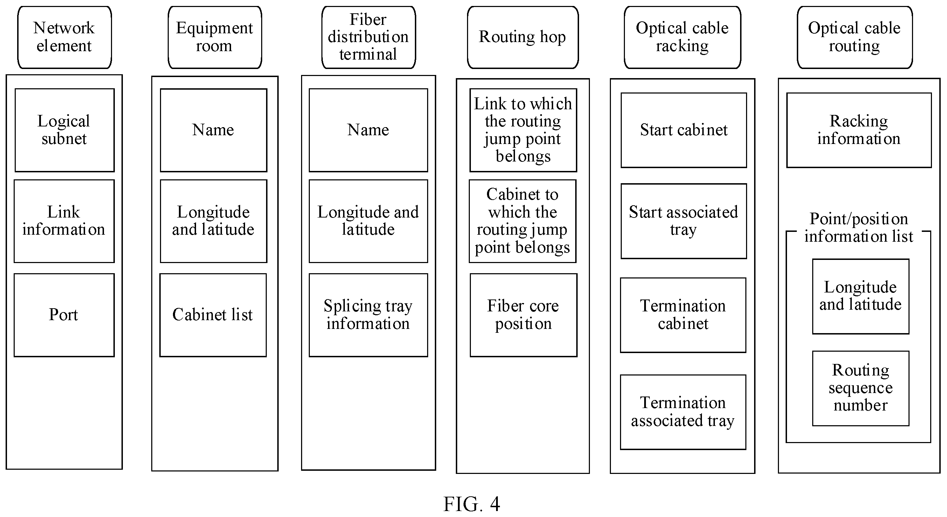

The element management module is configured to provide a function of querying network element information of a network element device in the optical fiber communication network. As shown in FIG. 4, the network element information includes network information, at least one piece of link information, and at least one piece of port information. The network information indicates a logical network to which the network element device belongs, and the logical network may be the optical fiber communication network or a logical subnet to which the network element device belongs in the optical fiber communication network. The link information indicates one link in the logical network and a network element port that the link passes through in the network element device. For example, the link information includes an identifier of the link and port information of the network element port. The port information indicates the network element port of the network device. Optionally, the element management module may be further configured to associate and bind the network element port of the network element device with a dumb optical line resource on the optical cable path, to facilitate user query.

The dumb optical line resource module is used to: define a general dumb optical line resource model, build a digital foundation (that is, a digital twin model) for dumb resources to restore an end-to-end physical topology of the optical cable path, and implement physical route restoration of an optical path and mapping of optical cable paths. Key information required for constructing the digital base for dumb resources includes at least one of hop information of each routing hop of the optical cable, racking information of each optical cable segment of the optical cable, a point/position information list of the optical cable path, equipment room information, and network element information. A routing hop refers to an end that an optical signal at a source of a specific optical cable passes through in a splicing tray in an optical cable routing node. One routing hop includes one input end and an output end. As shown in FIG. 4, the hop information includes at least one of link information of a link to which the routing hop belongs, cabinet information of a cabinet to which the routing hop belongs, and fiber core position information. The link to which the routing hop belongs refers to a link to which a source/sink, of an optical cable path to which the routing hop belongs, belongs. The cabinet information indicates the cabinet to which the routing hop belongs. The cabinet information may be position information of the cabinet, to indicate a geographical position of the cabinet. If the cabinet (for example, a cabinet of an ODF) to which the routing hop belongs is located in an equipment room, the position information of the cabinet includes longitude and latitude (briefly referred to as longitude & latitude) of the equipment room and position coordinates of the cabinet in the equipment room. If the cabinet (for example, a fiber distribution terminal) to which the routing hop belongs is not located in an equipment room, the position information of the cabinet includes longitude and latitude of the cabinet. The fiber core position information indicates a position of the routing hop in an optical cable routing node (the cabinet) to which the routing hop belongs. For example, the fiber core position information includes a splicing tray identifier of a splicing tray to which the routing hop belongs and an end identifier of the routing hop. The splicing tray identifier indicates one splicing tray. The splicing tray identifier may be a splicing tray number in an optical cable routing node to which the splicing tray belongs, or may be position coordinates of a splicing tray panel of the optical cable routing node to which the splicing tray belongs. The splicing tray panel is used for installation of a plurality of splicing trays. The end identifier indicates an end in one splicing tray, and the end identifier may be an end number in the splicing tray to which the end belongs. For one routing hop, a specific position of the routing hop may be positioned based on cabinet information and fiber core position information of the routing hop.

For an optical cable routing node located in the equipment room, equipment room information of the equipment room may be further used in a path modeling process. As shown in FIG. 4, the equipment room information includes a name of the equipment room, position information (for example, longitude and latitude), and a cabinet list. The cabinet list indicates each cabinet in the equipment room. The cabinet list includes a cabinet identifier of each cabinet in the equipment room. The cabinet identifier includes at least one of a cabinet number and position coordinates of the cabinet in the equipment room.

Racking information of any optical cable segment indicates a connection status between an optical fiber in the optical cable segment and a splicing tray in an optical cable routing node, and the racking information includes start racking information and termination racking information. The start racking information and the termination racking information respectively indicate a start racking position and a termination racking position of the optical cable segment, the start racking position is a connection position of an input end of the optical cable segment on a start routing node, the termination racking position is a connection position of an output end of the optical cable segment on a termination routing node, and the input end and the output end respectively refer to an end that is of the optical cable segment and that receives an optical signal and an end that is of the optical cable segment and that outputs an optical signal. The start routing node refers to an optical cable routing node connected to the input end of the optical cable segment. An end connected to the input end in the start routing node is referred to as a start end of the optical cable segment, and a splicing tray to which the start end belongs is referred to as a start associated tray of the optical cable segment. The termination routing node refers to an optical cable routing node connected to the output end of the optical cable segment. An end connected to the output end in the termination routing node is referred to as a termination end of the optical cable segment, and a splicing tray to which the termination end belongs is referred to as a termination associated tray of the optical cable segment. For example, as shown in FIG. 4, the start racking information includes cabinet information of a start cabinet and start associated tray information. The start cabinet refers to a cabinet to which the start routing node belongs. The start associated tray information indicates the start associated tray and the start end in the start associated tray. For example, the start associated tray information includes an associated tray identifier of the start associated tray and an end identifier of each start end. The termination racking information includes cabinet information of a termination cabinet and termination associated tray information. The termination cabinet refers to a cabinet to which the termination routing node belongs. The termination associated tray information indicates the termination associated tray and the termination end in the termination associated tray. For example, the termination associated tray information includes an associated tray identifier of the termination associated tray and an end identifier of each termination end.

The point/position information list of the optical cable path includes point/position information of each optical cable routing node on the optical cable path, and point/position information of any optical cable routing node indicates a geographical position of the optical cable routing node. As shown in FIG. 4, the point/position information includes position information (for example, longitude and latitude) of the optical cable routing node and a routing sequence number of the optical cable routing node. The routing sequence number is a routing hop count of the optical cable on the optical cable routing node. For example, a routing sequence number of the 1^{st} optical cable routing node (that is, the source routing node) on the optical cable path is 1, and a routing sequence number of the 2^{nd} optical cable routing node on the optical cable path is 2. Because the racking information of the optical cable segment may indicate a direction of an input/output optical signal on the optical cable segment, and the point/position information list may indicate a position of an optical cable routing node connected to each optical cable segment on the optical cable path, an approximate direction of the optical cable path may be determined by using the point/position information list of the optical cable path and racking information of an optical cable routing node indicated by each piece of point/position information.

The dumb optical line resource module is further configured to fit the approximate direction (where a small quantity of turning points including longitude and latitude information are connected) of the optical cable path with a network infrastructure of an actual non-routing node, for example, a man-hand hole or a pole, to obtain a real path (that is, the optical cable path) of the optical cable through mapping.

As shown in FIG. 1, the NMS 101 may be deployed on a cloud. In some other embodiments, the NMS 101 may not be deployed on the cloud. The NMS 101 may be implemented by using software, or may be implemented by using hardware, or may be implemented by using a combination of software and hardware. When the NMS 101 is implemented by using the software, all functional modules in the NMS 101 are software modules, the NMS 101 may be deployed in a server cluster, the server cluster includes at least one server, and the at least one server implements a function of the NMS 101 by running the software module of the NMS 101. When the NMS 101 is implemented by using the hardware, all functional modules in the NMS 101 are hardware modules. For example, each hardware module in the NMS 101 may be a server, or at least two hardware modules in the NMS 101 form a server. In this case, the NMS 101 is a server cluster, and includes at least one server. The terminal 102 may be portable user equipment having a photographing function, for example, a smartphone, a tablet computer, or a notebook computer.

With reference to an implementation environment shown in FIG. 1, the following uses

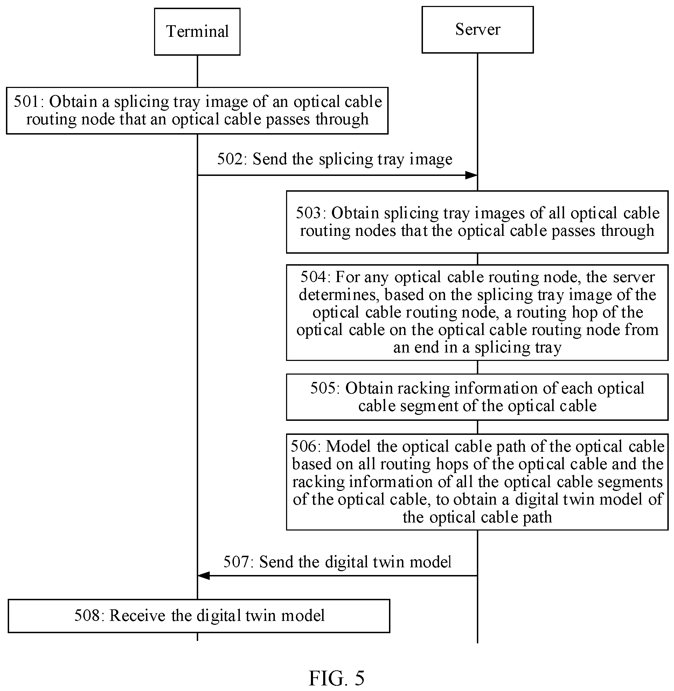

FIG. 5 as an example to describe in detail a model establishment method for an optical cable path on a server side and a model obtaining procedure for an optical cable path on a terminal side. The method includes the following steps.

501: A terminal obtains a splicing tray image of an optical cable routing node that an optical cable passes through, where the splicing tray image is used to present a splicing tray in the optical cable routing node and an end in the splicing tray.

The optical cable is used to transmit an optical signal that is transmitted between network element ports of any two network devices. The optical cable includes at least one optical cable segment, and the optical cable routing node that the optical cable passes through is an optical cable routing node connected to the at least one optical cable segment. A splicing tray image of any optical cable routing node is a real-world image of a splicing tray in the optical cable routing node. The splicing tray image is a panoramic splicing tray image or a plurality of partial splicing tray images. Each splicing tray in the optical cable routing node and each end in the splicing tray are displayed in the panoramic splicing tray image, and a part of splicing trays in the optical cable routing node and each end in the part of splicing trays are displayed in each partial splicing tray image. For example, the optical cable routing node has eight splicing trays, three splicing trays are displayed in one partial splicing tray image, and five splicing trays are displayed in another partial splicing tray image.

The terminal may obtain a splicing tray image of each optical cable routing node on an optical cable path. A process of obtaining the splicing tray image of each optical cable routing node is similar. Next, the following uses an example of obtaining a splicing tray image of any optical cable routing node to describe a process in which the terminal obtains the splicing tray image.

A client of an NMS is installed in the terminal, and the client provides a path selection interface. The path selection interface includes at least one path modeling option, each path modeling option corresponds to one port pair in an optical fiber communication network, each path modeling option indicates to perform digital twin modeling on an optical cable path between corresponding port pairs, and the digital twin modeling refers to establishing a digital twin model of the optical cable path. A user performs a click operation on a path modeling option corresponding to a port pair including a source and a sink of the optical cable, and the terminal displays a path modeling interface of the optical cable path of the optical cable in response to the click operation.

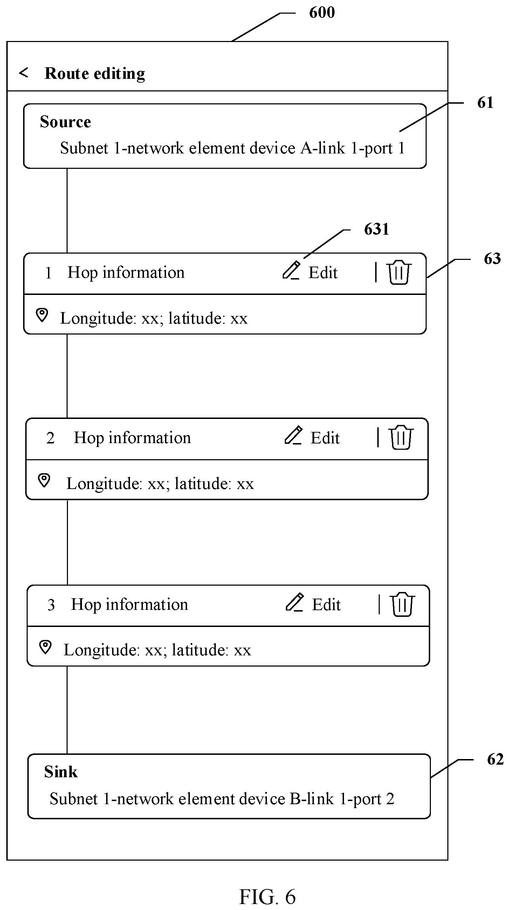

A path modeling interface 600 shown in FIG. 6 is used as an example. The path modeling interface 600 includes a source information box 61, a sink information box 62, and at least one routing option 63. The source information box 61 and the sink information box 62 are respectively used to display port information of the source of the optical cable and port information of the sink of the optical cable. For either of network element ports in the source and the sink, the port information indicates a position of the port in the optical fiber communication network. For example, the port information includes a port number of a network element device to which the network element port belongs, a name of the network element device to which the network element port belongs, and a name of a link to which the network element port belongs. An optical cable path between a network element port 1 of a network element device A and a network element port 2 of a network element device B is used as an example. It is assumed that the network element port 1 is a source, and the network element port 2 is a sink. Port information of the source/sink is shown in FIG. 6. Each routing option 63 corresponds to one optical cable routing node connected to the optical cable, and the routing option 63 is used to record a routing hop of the optical cable on the corresponding optical cable routing node. The routing option 63 is further used to display a routing hop count of the routing hop. The routing hop count indicates a ranking of the routing hop in all routing hops on the optical cable path. As shown in FIG. 6, routing hop counts are 1 to 3, which respectively indicates the 1^{st} routing hop, the 2^{nd} routing hop, and the 3^{rd} routing hop on the optical cable path.

For a routing hop of the optical cable on the optical cable routing node, the user selects, based on a routing hop count of the routing hop, a routing option 63 including the routing hop count, and performs a click operation on an edit option 631 in the routing option 63. The edit option 631 indicates to record related information of the routing hop. In response to the click operation, a procedure of recording the related information of the routing hop is entered. In the recording procedure, the terminal is triggered to obtain a splicing tray image of the optical cable routing node to which the routing hop belongs. For example, the following step A1 and step A2 are performed.

Step A1: The terminal displays a cabinet model of the optical cable routing node, where the cabinet model indicates a cabinet to which the optical cable routing node belongs and a position of the cabinet in the optical fiber communication network.

The cabinet model includes a cabinet identifier and position information of the cabinet, and the cabinet identifier may be at least one of an icon and a text that are used to represent the cabinet. The position information indicates the position of the cabinet in the optical fiber communication network, for example, longitude and latitude of the cabinet.

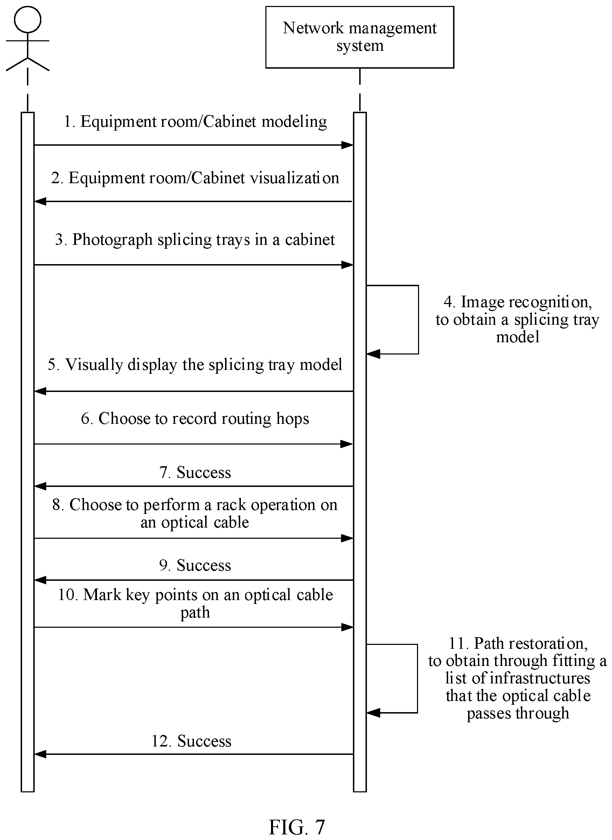

If the cabinet is located in an equipment room, the cabinet model is located in an equipment room model of the equipment room. For example, if the optical cable routing node is an ODF, the cabinet model is located in an equipment room model of an equipment room to which the ODF belongs. If the cabinet is not located in an equipment room, the cabinet model is irrelevant to the equipment room. A timing diagram for entry of dumb optical line resources shown in FIG. 7 is used as an example. The user may indicate, through the terminal and depending on whether the cabinet is located in the equipment room, to run the network management system to perform equipment room/cabinet modeling. After completing the equipment room/cabinet modeling, the network management system visually displays an equipment room/cabinet model to the user through the terminal. The user takes a photo of a splicing tray image in the cabinet through the terminal and based on the displayed equipment room model/cabinet model, to obtain the splicing tray image. Next, the following uses an example in which the network management system is run in a server to describe cabinet modeling processes in two cases: the cabinet is located in the equipment room and the cabinet is not located in the equipment room.

The following describes, through step 11 and step 12, the process of establishing the cabinet model when the cabinet is not located in the equipment room.

11: In response to an edit operation, in the path modeling interface, on the routing option corresponding to the optical cable routing node, the terminal sends a cabinet modeling request to the server, where the cabinet modeling request indicates to model the cabinet to which the optical cable routing node belongs.

The edit operation indicates to record the related information of the routing hop. The cabinet modeling request includes a name of the cabinet.

FIG. 6 is used as an example. The user performs a click operation on the edit option 631 in the routing option 63 corresponding to the optical cable routing node, to implement the edit operation. In response to the click operation on the edit option 631, the terminal displays an information recording window. The information recording window includes an equipment room model option and a cabinet model option. The equipment room model option indicates to record the related information of the routing hop based on the equipment room model, and the cabinet model option indicates to record the related information of the routing hop based on a cabinet model in a non-equipment room model. If the cabinet to which the optical cable routing node (for example, a fiber distribution terminal) belongs is not located in the equipment room, the user performs a click operation on the cabinet model option, and in response to the click operation, the terminal displays a cabinet selection interface. The cabinet selection interface is used to select a cabinet for which a model is to be established, the cabinet selection interface includes a plurality of cabinet options, and each cabinet option corresponds to one cabinet that is not located in the equipment room. The user performs a click operation on a cabinet option of the cabinet to which the optical cable routing node belongs, and in response to the click operation, the terminal sends the cabinet modeling request to the server.

12: The server sends the cabinet model of the cabinet to the terminal based on the cabinet modeling request, and the terminal receives and displays the cabinet model.

For example, the server queries the position information of the cabinet based on the name of the cabinet in the cabinet modeling request, generates the cabinet model based on the position information of the cabinet and the cabinet identifier, and sends the cabinet model to the terminal. After receiving the cabinet model, the terminal displays a model display interface based on the cabinet model. The model display interface includes the cabinet model.

Next, the following describes, through the following step 1a to step 1c, the process of establishing the equipment room model and the cabinet model when the cabinet is located in the equipment room.

1a: In response to an edit operation, in the path modeling interface, on the routing option corresponding to the optical cable routing node, the terminal sends an equipment room modeling request to the server, where the equipment room modeling request indicates to model the equipment room to which the optical cable routing node belongs.

The equipment room modeling request includes a name of the equipment room.

As described in step 11, in response to the edit operation, the terminal displays the information recording window. If the cabinet to which the optical cable routing node (for example, the ODF) belongs is located in the equipment room, the user performs a click operation on the equipment room model option in the information recording window, and in response to the click operation, displays an equipment room selection interface. The equipment room option interface is used to select an equipment room for which an equipment room model is to be established, the equipment room selection interface includes a plurality of equipment room options, and each equipment room option corresponds to one equipment room. The user performs a click operation on an equipment room option of the equipment room to which the optical cable routing node belongs, and in response to the click operation, the terminal sends the equipment room modeling request to the server.

1b: If the equipment room model of the equipment room has not been established, send an equipment room model template to the terminal based on the equipment room modeling request, where the equipment room model template includes a plurality of cabinet areas, and the cabinet area is used to present one cabinet in the equipment room.

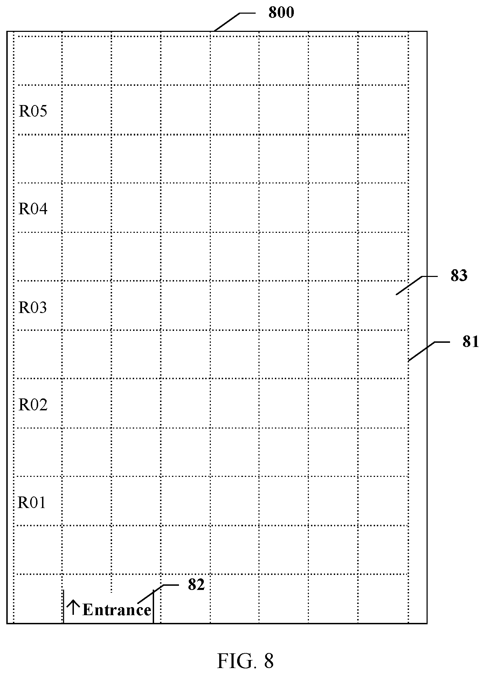

The equipment room model template is a template for the equipment room model. An equipment room model template 800 shown in FIG. 8 is used as an example. The equipment room model template 800 includes a cabinet area array 81 and an entrance 82. All cabinet areas 83 in the cabinet area array 81 are empty. The user may add a cabinet identifier to each cabinet area by performing an operation, to obtain an equipment room model. In a possible implementation, the equipment room model template 800 further includes at least one of a row number of at least one row of cabinet areas 83 and/or a column number. Optionally, the row number is represented by "RX", where R represents a row, X represents a number, and RX represents an X^{th} row. For example, R01 represents the 1^{st} row. In some other embodiments, "RX" may also be abbreviated as "X".

The row number of the row of cabinet areas 83 or the column number is numbered based on a relative position between a row/column in which the cabinet area 83 is located and the entrance 81. For example, if any row of cabinet areas 83 is opposite to the entrance 82, a row number of the row of cabinet areas 83 indicates that the row of cabinet areas 83 is a specific row of cabinet areas 83 opposite to the entrance 82. For example, R01 represents the 1^{st} row of cabinet areas 83 opposite to the entrance 82. If any column of cabinet areas 83 is opposite to the entrance 82, a column number of the column of cabinet areas 83 indicates that the column of cabinet areas 83 is a specific column of cabinet areas 83 opposite to the entrance 82. The row number and/or the column number of the cabinet area 83 are/is displayed, so that the user can quickly position the cabinet area 83 corresponding to the cabinet to be modeled, and perform cabinet modeling based on the corresponding cabinet area 83.

After receiving the equipment room modeling request, the server queries the equipment room model of the equipment room from an equipment room model library based on the name of the equipment room in the equipment room modeling request. The equipment room model library includes an equipment room model of at least one equipment room. If the equipment room model of the equipment room is found, the equipment room model is sent to the terminal. After receiving the equipment room model, the terminal displays a model display interface based on the equipment room model. The model display interface includes the equipment room model. If the equipment room model of the equipment room cannot be found, the equipment room model template is sent to the terminal, to indicate the terminal to perform equipment room modeling based on the equipment room model template.

1c: The terminal receives and displays the equipment room model template, and in response to a cabinet adding operation on any cabinet area, adds a cabinet identifier to the cabinet area, to obtain the equipment room model of the equipment room, where the cabinet identifier indicates a cabinet at a position corresponding to the cabinet area in the equipment room.

The cabinet adding operation indicates to add a cabinet model based on a corresponding cabinet area. The cabinet adding operation is, for example, a click operation.

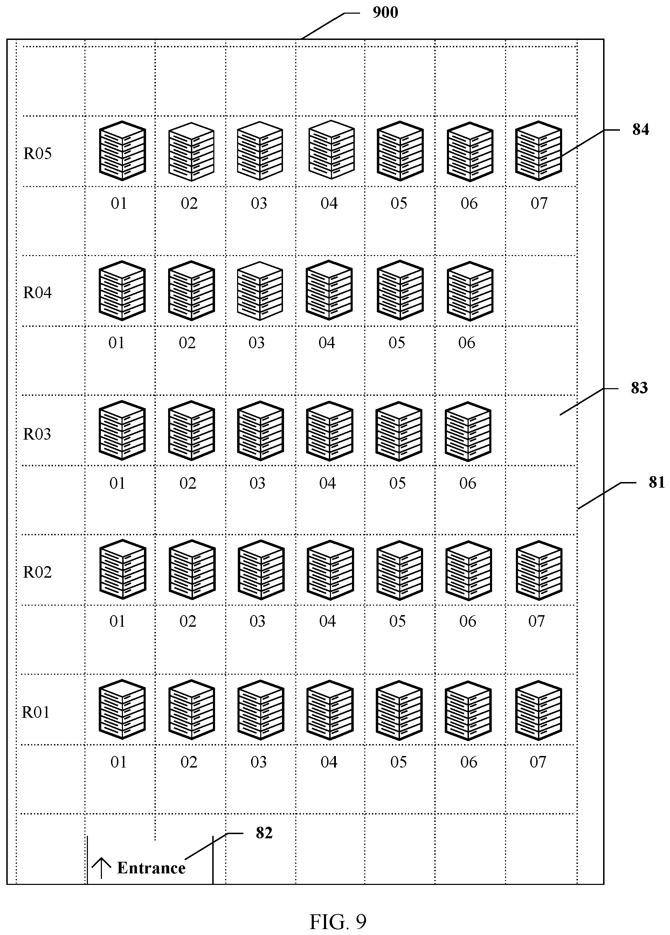

After receiving the equipment room model template, the terminal displays an equipment room modeling interface based on the equipment room model template. The equipment room modeling interface includes the equipment room model template. For the cabinet to which the optical cable routing node belongs in the equipment room, an entrance of the equipment room is used as a reference position, and a position of the cabinet opposite to the entrance is used as a relative position of the cabinet. The user searches for a target cabinet area in the plurality of cabinet areas 83 based on the relative position and a position of the entrance 82 in the equipment room model template. The target cabinet area is a cabinet area corresponding to the cabinet in the equipment room model, and a position of the target cabinet area in the equipment room model template relative to the entrance is the same as the relative position. The user performs a cabinet adding operation on the target cabinet area. In response to the cabinet adding operation, the terminal adds a cabinet identifier to the target cabinet area and displays the cabinet identifier, to indicate that there is one cabinet at a position corresponding to the target cabinet area in the equipment room. FIG. 9 is used as an example. It is assumed that the cabinet is a cabinet that is in a cabinet array, that is in the 5^{th} row and the 7^{th} column, and that is away from the entrance of the equipment room. The user uses a cabinet area 83 that is in the 5^{th} row and the 7^{th} column and that is away from the entrance 82 in the equipment room model template as the target cabinet area, and performs a click operation on the cabinet area 83 in the 5^{th} row and the 7^{th} column, to complete the cabinet adding operation on the target cabinet area. The terminal adds a cabinet identifier 84 to the cabinet area 83 in the 5^{th} row and the 7^{th} column in response to the operation.

The user may add cabinets in the equipment room to the equipment room model template in a similar manner. The equipment room modeling interface further includes a cabinet addition completion option, and the cabinet addition completion option indicates that a cabinet in the equipment room has been added. After adding at least one cabinet to the equipment room model template, the user performs a click operation on the cabinet addition completion option. In response to the click operation, the terminal adds, based on each cabinet area that includes a cabinet identifier and an entrance in the equipment room model template, relative position coordinates of each cabinet area to an associated position of the cabinet area, to indicate a relative position between a cabinet indicated by the cabinet identifier in the cabinet area and the entrance of the equipment room. The relative position coordinates are represented by (RX, Y), and "Y" is a column number, and indicates that the cabinet is located in a Y^{th} column of the cabinet array relative to the entrance of the equipment room. The associated position of the cabinet area refers to a position around the cabinet area, for example, an upper part, a lower part, a left part, or a right part of the cabinet area; or there are two associated positions: One is an upper part or a lower part of the cabinet area in a column to which the cabinet area belongs, and the other is a row head or a row tail of a row to which the cabinet area belongs; or one is a column head or a column tail of a column to which the cabinet area belongs, and the other is a row head or a row tail of a row to which the cabinet area belongs. The associated position of the cabinet area is not limited in embodiments of this application.

An equipment room model 900 shown in FIG. 9 is still used as an example. For at least one row of cabinet areas 83 that includes a cabinet identifier 84 in the cabinet area array 81, based on the entrance 82 as a reference position, the terminal numbers a row coordinate of the at least one row of cabinet areas 83, to obtain a row number of each row of cabinet areas 83, numbers a column coordinate of each column of cabinet areas 83 to obtain a column number of each column of cabinet areas 83, adds the row number of each row of cabinet areas 83 to a right part (that is, a row head) of a corresponding row of cabinet areas, and adds the column number of each cabinet area in each column of cabinet areas 83 to a lower part of the corresponding cabinet area 83. Certainly, a column number may not be added to an empty cabinet area 83, and the empty cabinet area does not include a cabinet identifier 84.

When a cabinet identifier and relative position coordinates of any cabinet are added to the equipment room model template, cabinet model modeling of the cabinet is completed. In this case, the cabinet model includes the cabinet identifier and the relative position coordinates of the cabinet. After modeling of the at least one cabinet in the equipment room is completed in the equipment room model template, the user performs an equipment room modeling completion operation on the equipment room model template. The equipment room modeling completion operation indicates that the equipment room modeling is completed based on the equipment room model template. In response to the equipment room modeling completion operation, the terminal determines the equipment room model template including the at least one cabinet model as the equipment room model (for example, the equipment room model 900 shown in FIG. 9) of the equipment room, to complete the equipment room modeling, for example, the equipment room model shown in FIG. 9. The terminal displays a model display interface based on the equipment room model. The model display interface includes the equipment room model. The terminal further sends the equipment room model to the server, to indicate that establishment of the equipment room model is completed. After receiving the equipment room model, the server may add the equipment room model to the equipment room model library for subsequent query.

Based on the equipment room modeling process shown in step 1b to step 1c, the user may determine a relative position of a cabinet in the equipment room based on the entrance provided by the equipment room model template, and visually edit the cabinet in the equipment room model template, so that relative position coordinates of the cabinet are automatically generated, and the cabinet modeling is quickly completed. In this way, the equipment room modeling can be quickly completed, and modeling efficiency of the cabinet and the equipment room can be improved. The foregoing is described by using an example in which the cabinet identifier is first added to the equipment room model template, and then the relative position coordinates are added to the cabinet area to which the cabinet identifier belongs. In some other embodiments, relative position coordinates of each cabinet area are displayed at an associated position of the cabinet area in the equipment room model, and the cabinet identifier is added to the equipment room model template, to complete the cabinet modeling.

Step A2: In response to an image obtaining operation on the cabinet model of the optical cable routing node, the terminal obtains the splicing tray image of the optical cable routing node.

The image obtaining operation indicates to obtain the splicing tray image of the optical cable routing node in the cabinet corresponding to the cabinet model.

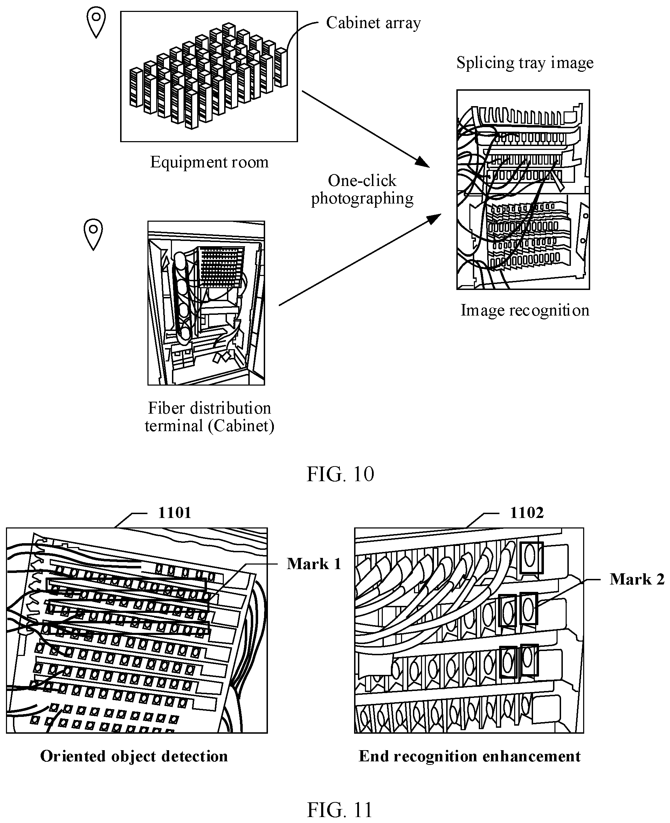

The model display interface includes an image obtaining option, and the image obtaining option indicates to obtain the splicing tray image. The user performs a click operation on the cabinet identifier in the cabinet model of the optical cable routing node in the model display interface, and performs a click operation on the image obtaining option, to complete the image obtaining operation. In response to the image obtaining operation, the terminal enables an image photographing function of a camera of the terminal. The user uses the camera of the terminal to photograph a splicing tray in the cabinet to which the optical cable routing node belongs, and the terminal obtains a photographed image as the splicing tray image of the optical cable routing node. As shown in FIG. 10, if the cabinet indicated by the cabinet model is the cabinet in the equipment room, the terminal may be triggered, by using the image obtaining option, to perform one-click photographing on the cabinet in the equipment room, to obtain the splicing tray image; or if the cabinet indicated by the cabinet model is a fiber distribution terminal, the terminal may be triggered, by using the image obtaining option, to perform one-click photographing on the fiber distribution terminal, to obtain the splicing tray image.

In a possible implementation, the image obtaining option includes a panoramic image obtaining option and a partial image obtaining option, the panoramic image obtaining option is used to obtain a panoramic splicing tray image of the optical cable routing node, and the partial image obtaining option is used to obtain a partial splicing tray image of the optical cable routing node. For example, if the user performs a click operation on the panoramic image obtaining option, the user uses the camera of the terminal to photograph the panoramic splicing tray image of the optical cable routing node, and the terminal obtains a photographed image as the splicing tray image of the optical cable routing node; or if the user performs a click operation on the partial image obtaining option, the user uses the camera of the terminal to photograph a plurality of partial splicing tray images of the optical cable routing node, and the terminal obtains a plurality of photographed images as partial splicing tray images of the optical cable routing node.

The foregoing is described by using an example in which the splicing tray image is obtained in a photographing manner. In some other embodiments, the terminal may alternatively obtain the splicing tray image from a local image library. For example, in response to the image obtaining operation, the terminal opens the local image library, and the user selects the splicing tray image from the local image library. The terminal obtains the image selected by the user as the splicing tray image of the optical cable routing node.

After obtaining the splicing tray image of the optical cable routing node, the terminal may further display the obtained splicing tray image, so that the user confirms whether the obtained splicing tray image is clear. If the obtained splicing tray image is a plurality of partial splicing tray images, and an arrangement manner of the plurality of partial splicing tray images is different from an arrangement manner of splicing trays in the optical cable routing node, the user may further adjust the arrangement manner of the plurality of displayed partial splicing tray images, so that an adjusted arrangement manner of the plurality of partial splicing tray images is the same as the arrangement manner of the splicing trays in the optical cable routing node. For example, the optical cable routing node includes splicing trays 1 to 8, the splicing trays 1 to 8 are sequentially arranged in the optical cable routing node from top to bottom, there are two partial splicing tray images of the optical cable routing node, which are partial splicing tray images 1 to 4, and the splicing trays 5 to 8 are displayed in the partial splicing tray image 2. If the terminal sequentially displays the partial splicing tray image 2 and the partial splicing tray image 1 from top to bottom, such a display manner is different from an actual arrangement manner of the splicing trays 1 to 8. In this case, the user may adjust the partial splicing tray image 1 to be above the partial splicing tray image 2, so that an arrangement manner of the partial splicing tray images 1 and 2 is the same as the arrangement manner of the corresponding splicing trays. In this way, subsequently, the arrangement manner of the splicing trays in the optical cable routing node can be accurately recognized based on the arrangement manner of the plurality of partial splicing tray images.

502: The terminal sends the splicing tray image of the optical cable routing node to the server.

503: The server obtains splicing tray images of all optical cable routing nodes that the optical cable passes through.

The terminal may provide, for the server based on the processes described in the foregoing steps 501 and 502, the splicing tray image of each optical cable routing node that the optical cable passes through, so that the server receives all the splicing tray images of all optical cable routing nodes that the optical cable passes through. In some other embodiments, the splicing tray images of the optical cable routing nodes that the optical cable passes through are provided by a plurality of terminals, and each terminal provides splicing tray images of some of the optical cable routing nodes that the optical cable passes through. For a process in which each terminal provides the splicing tray image of each optical cable routing node, refer to step 501 and step 502.

504: For any optical cable routing node, the server determines, based on the splicing tray image of the optical cable routing node, a routing hop of the optical cable on the optical cable routing node from the end in the splicing tray.

Routing hops include an input routing hop and an output routing hop. The input routing hop refers to an end that an optical signal at the source of the optical cable passes through in ends in the splicing tray in the optical cable routing node. The output routing hop refers to an end that the optical signal passes through in the splicing tray in the optical cable routing node. The optical cable path shown in FIG. 1 is used as an example. It is assumed that the fiber patch cord 1 is connected to an input end 1 within the splicing tray in the optical cable routing node A, and the input end 1 is connected to a specific optical fiber in the optical cable segment 1 through an output end 5 in the splicing tray in the optical cable routing node A. In this case, the input end 1 and the output end 5 are respectively an input routing hop and an output routing hop of the optical cable on the optical cable path in the optical cable routing node A.

In a possible implementation, the server recognizes each splicing tray in the optical cable routing node and an end in each splicing tray by using the splicing tray image of the optical cable routing node, and determines a routing hop of the optical cable on the optical cable routing node from the recognized end. The following describes this implementation through the following step 541 and step 542.

Step 541: The server establishes a splicing tray model of the optical cable routing node based on the splicing tray image of the optical cable routing node, where the splicing tray model indicates each splicing tray in the optical cable routing node and each end in the splicing tray.

The splicing tray model further indicates at least one of a relative position between splicing trays in the optical cable routing node and a connection state of each end in each splicing tray. A connection state of any end indicates whether the end is connected to an optical fiber.

In a possible implementation, the server establishes the splicing tray model based on a splicing tray recognition model and the splicing tray image of the optical cable routing node, for example, performs the following step B1 to step B3.

B1: The server obtains a splicing tray recognition model, where the splicing tray model is used to recognize the splicing tray in the splicing tray image and the end in the splicing tray.

The splicing tray recognition model is an image detection model based on artificial intelligence (artificial intelligence, AI), for example, a neural network model or a deep learning model. The splicing tray recognition model may be a target detection model (you only look once, YOLO) of any version, for example, the fifth version of YOLO (YOLO v5). Herein, the splicing tray recognition model is not limited in embodiments of this application, provided that the splicing tray and the end in the splicing tray in the splicing tray image can be recognized.

The splicing tray recognition model is obtained by the server through training based on a plurality of sample images, or is obtained by another device other than the server through training based on a plurality of sample images. After obtaining the splicing tray recognition model through training or obtaining the splicing tray recognition model from the another device, the server may store the splicing tray recognition model locally or in a database, and obtain the splicing tray recognition model locally or from the database when a splicing tray model needs to be established.

A process in which the server or the another device trains the splicing tray recognition model based on training data is similar to this. Herein, the following describes the process by using an example in which the server trains the splicing tray recognition model.

The user prepares a plurality of sample images, and each sample image is a splicing tray image. As shown in FIG. 11, the user marks a part of a splicing tray area and a part of an end area in each sample image. Each splicing tray area includes one splicing tray, and each end area includes one end. The sample image shown in FIG. 11 is used as an example. A mark 1 in a sample image 1101 indicates a splicing tray, and a mark 2 in a sample image 1102 indicates an end in the splicing tray. The user attaches a splicing tray label to each marked splicing tray area, and attaches an end label to each marked end area. The splicing tray label indicates that an object in a corresponding area is a splicing tray, and the end label indicates that an object in a corresponding area is an end. Optionally, the end label further indicates a connection state of the end. The server constructs a training set and a test set based on a plurality of marked sample images and a splicing tray label and an end label of each sample image. The training set includes a part of marked sample images and splicing tray labels and end labels of the part of sample images. A verification set includes remaining marked sample images and splicing tray labels and end labels of the remaining sample images.

The server performs iterative training on a first splicing tray recognition model based on a plurality of sample images in the training set and splicing tray labels and end labels of the plurality of sample images, to obtain a second splicing tray recognition model, so that the second splicing tray recognition model learns a capability of recognizing a splicing tray and an end in the splicing tray from a splicing tray image. The second splicing tray recognition model is verified by using the verification set, and if the second splicing tray recognition model succeeds in the verification, the second splicing tray recognition model is determined as the splicing tray recognition model obtained through training.

In some other possible implementations, as shown in FIG. 11, a part of sample images in a sample set may be splicing tray images with tilted splicing trays, so that the trained splicing tray recognition model can accurately recognize splicing trays in the image with the tilted splicing trays, to implement oriented object detection. A part of sample images may be enlarged partial splicing tray images, and ends are marked in a part of partial splicing trays, so that a splicing tray recognition model that is being trained can learn an end recognition capability as soon as possible, and the end recognition capability of the trained splicing tray recognition model is enhanced.

B2: The server performs, based on the splicing tray recognition model, splicing tray recognition on the splicing tray image of the optical cable routing node, to obtain splicing tray information of the optical cable routing node.

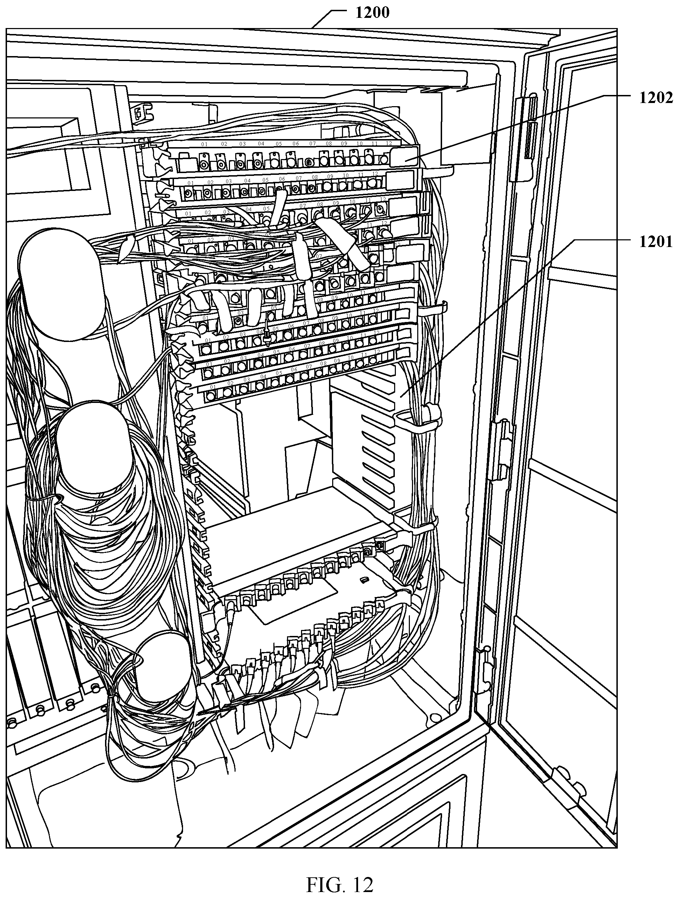

The splicing tray information includes a quantity of splicing trays in the optical cable routing node, position coordinates of each splicing tray, and a quantity of ends in the splicing tray. The quantity of splicing trays refers to a quantity of splicing trays in the optical cable routing node. The quantity of splicing trays is an optional item. In some embodiments, the splicing tray information does not include the quantity of splicing trays. Position coordinates of any splicing tray indicate a relative position of the splicing tray in each splicing tray in the optical cable routing node. A vertex of a splicing tray panel in the optical cable routing node is used as an origin, and the splicing tray panel is used as a coordinate system. The position coordinates of the splicing tray are position coordinates of the splicing tray on the splicing tray panel. The splicing tray panel refers to a panel used for installation of the splicing tray, for example, a splicing tray panel 1201 in a splicing tray image 1200 shown in FIG. 12. The quantity of ends refers to a quantity of ends in the splicing tray. In some other embodiments, the splicing tray information further includes a connection state identifier of each end in each splicing tray, to indicate a connection state of each end.

The server inputs the splicing tray image of the optical cable routing node into the splicing tray recognition model. If one splicing tray image is input, the splicing tray recognition model uses the input splicing tray image as a panoramic splicing tray image. If a plurality of splicing tray images are input, the plurality of input splicing tray images are used as partial splicing tray images, the plurality of splicing tray images are combined into a panoramic splicing tray image, and splicing tray recognition is performed on the obtained panoramic splicing tray image, to determine each splicing tray in the optical cable routing node, a relative position between splicing trays, and an end in the splicing tray, and splicing tray information is output based on each splicing tray in the optical cable routing node, the relative position between the splicing trays, and each end in the splicing tray.

B3: The server generates the splicing tray model based on the splicing tray information.

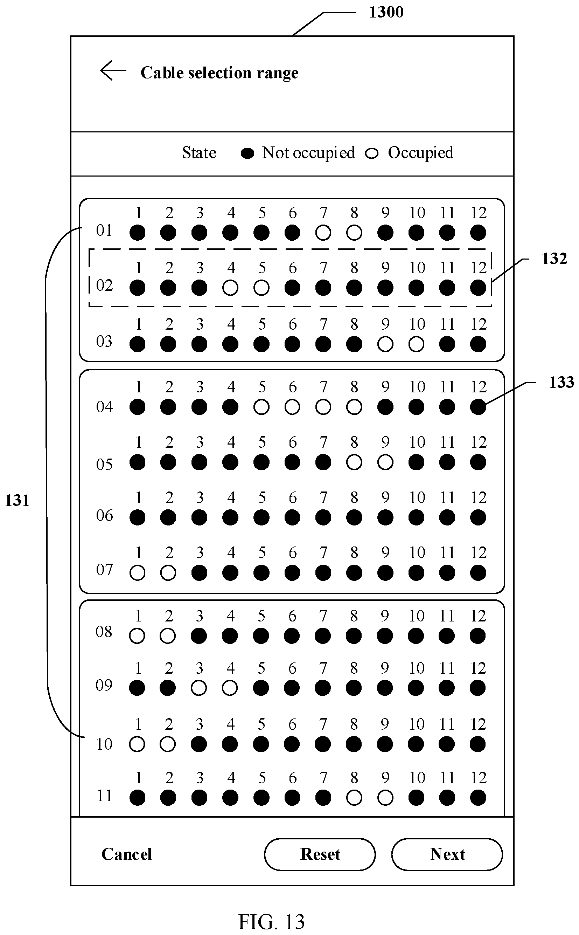

A splicing tray model 131 shown in FIG. 13 is used as an example. The splicing tray model 131 includes at least one first splicing tray option 132, and each first splicing tray option 132 indicates one splicing tray in the optical cable routing node. Optionally, an arrangement manner of the at least one first splicing tray option 132 in the splicing tray model is the same as an indicated arrangement manner of the splicing tray on the splicing tray panel.

In a possible implementation, for any first splicing tray option 132, the splicing tray model 131 further includes position coordinates of a splicing tray indicated by the first splicing tray option 132, and the position coordinates may be a row number or a column number of the splicing tray on the splicing tray panel. For example, if the splicing tray is installed by row on the splicing tray panel, the position coordinates are the row number of the splicing tray on the splicing tray panel, or if the splicing tray is installed by column on the splicing tray panel, the position coordinates are the column number of the splicing tray on the splicing tray panel. Alternatively, the position coordinates may be a number of the splicing tray in all splicing trays on the splicing tray panel, and the number indicates a specific splicing tray in all the splicing trays. A position of the splicing tray on the splicing tray panel is indicated by using position coordinates corresponding to the first splicing tray option 132. For example, position coordinates of the first splicing tray option 132 shown in the 5^{th} row in FIG. 13 are "5", indicating the 5^{th} splicing tray installed on the splicing tray panel.

In a possible implementation, for any first splicing tray option 132, the first splicing tray option 132 further includes a plurality of first end options 133, and each first end option 133 indicates one end in a splicing tray indicated by the first splicing tray option 132.

In a possible implementation, for any first splicing tray option 132, the first splicing tray option 132 further includes an end number of each first end option 133, to indicate a position of a corresponding end in a splicing tray.

In a possible implementation, for any first end option 133, a connection state of a corresponding end is indicated by using different display forms of the first end option 133. FIG. 13 is used as an example. A first end option 133 filled in black indicates that a corresponding end is connected to an optical fiber, to indicate that the end is occupied, and an end option 133 not filled in black indicates that a corresponding end is not connected to an optical fiber, to indicate that the end is not occupied. Certainly, in some other embodiments, alternatively, whether the end is connected to an optical fiber may be indicated by another icon, text, or special effect other than a black fill. Herein, a manner of representing the connection state of the end in the splicing tray model is not limited in embodiments of this application.

The foregoing plurality of implementations related to the splicing tray model may be randomly combined, to obtain more implementations of the splicing tray model. A combination manner is not limited herein in embodiments of this application.

Step 542: The server determines, based on the splicing tray model, a routing hop of the optical cable on the optical cable routing node.

As shown in FIG. 7, a network optical cable system in the server provides the splicing tray model for the terminal, and the terminal obtains the splicing tray model, and visually displays the splicing tray model. The user specifies a routing hop based on the displayed splicing tray model. Next, this implementation is described through the following step C1 to step C5.

C1: The server sends a hop confirmation request to the terminal based on the splicing tray model, where the hop confirmation request indicates to confirm the routing hop based on the splicing tray model. The hop confirmation request includes the splicing tray model.

C2: The terminal displays the splicing tray model of the optical cable routing node based on the hop confirmation request.

After receiving the hop confirmation request, the terminal obtains the splicing tray model from the hop confirmation request, and displays the first splicing tray interface based on the splicing tray model. The first splicing tray interface includes the splicing tray model, for example, the first splicing tray interface 1300 shown in FIG. 13.

In another possible implementation, the terminal generates a simplified splicing tray model based on the splicing tray model, and displays a second splicing tray interface based on the simplified splicing tray model. The second splicing tray interface includes the simplified splicing tray model. The user may perform a splicing tray model display operation on the simplified splicing tray model, to indicate to display the splicing tray model corresponding to the simplified splicing tray model. In response to the operation, the terminal displays the first splicing tray interface based on the simplified splicing tray model.

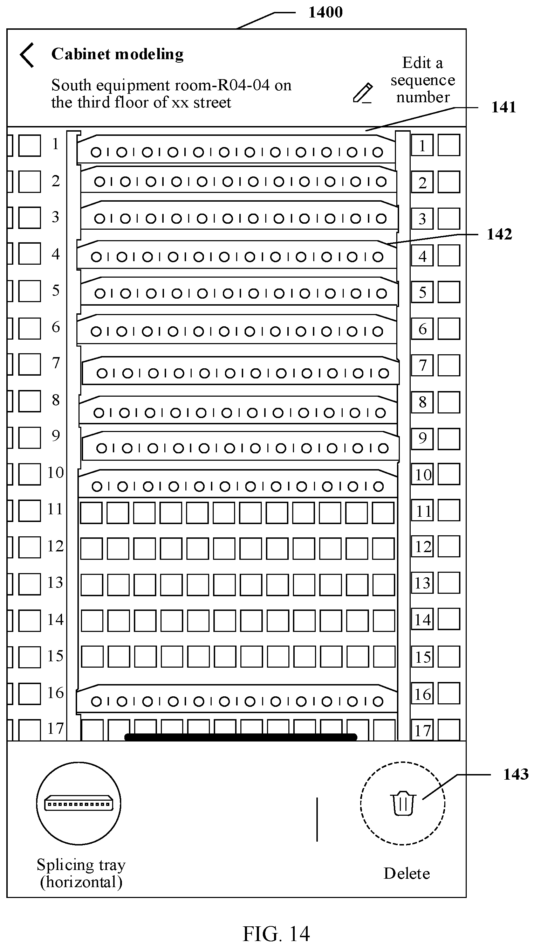

The simplified splicing tray model is a simplified model of the splicing tray model, and the simplified splicing tray model indicates each splicing tray in the optical cable routing node. The simplified splicing tray model is a visualized list of splicing trays in the optical cable routing node. A simplified splicing tray model 141 in a second splicing tray interface 1400 shown in FIG. 14 is used as an example. The simplified splicing tray model 141 includes at least one second splicing tray option 142, the at least one second splicing tray option 142 corresponds to one first splicing tray option in the splicing tray model, any second splicing tray option 142 and a corresponding first splicing tray option indicate a same splicing tray, and the second splicing tray option 142 and the first splicing tray option may have a same appearance or different appearances.

In another possible implementation, an arrangement manner of the second splicing tray option 142 in the simplified splicing tray model 141, an arrangement manner of a first splicing tray option in a splicing tray model to which the simplified splicing tray model 141 belongs, and an arrangement manner of a splicing tray in a corresponding splicing tray image are the same. For example, the splicing tray image corresponding to the simplified splicing tray model 141 is the splicing tray image 1200 shown in FIG. 12. An arrangement manner of a splicing tray 1202 in the splicing tray image 1200 on the splicing tray panel 1201 is the same as an arrangement manner of the second splicing tray option 142 in the simplified splicing tray model 141.

In another possible implementation, the simplified splicing tray model 141 further includes position coordinates corresponding to the second splicing tray option 142, and the position coordinates are position coordinates corresponding to the first splicing tray option, for example, position coordinates 1 to position coordinates 17 in the simplified splicing tray model 142.

The foregoing plurality of implementations related to the simplified splicing tray model may be randomly combined, to obtain more implementations of the simplified splicing tray model. A combination manner is not limited herein in embodiments of this application.

Optionally, as shown in FIG. 14, the second splicing tray interface 1400 further includes a delete option 143, and the delete option 143 indicates to delete the second splicing tray option 142. For example, if there are excessive second splicing tray options 142 in the simplified splicing tray model 141 relative to a splicing tray actually installed in the optical cable routing node, the user may perform a click operation on the delete option 143. In response to the click operation, a simplified splicing tray model 141 in an editable state is displayed in the second splicing tray interface 1400. The user specifies a to-be-deleted second splicing tray option 142 in the simplified splicing tray model 141 in the editable state, and the terminal deletes the second splicing tray option 142 specified by the user. Correspondingly, the terminal further deletes, from the splicing tray model, a first splicing tray option corresponding to the deleted second splicing tray option 142, to update the splicing tray model. In some other embodiments, the second splicing tray interface 1400 further includes cabinet information "south equipment room-R04-04 on the third floor of xx street" of the optical cable routing node, to indicate a position of a cabinet to which the optical cable routing node belongs.

In another possible implementation, the hop confirmation request includes the splicing tray information, but does not include a splicing tray model. The terminal generates a simplified splicing tray model and/or a splicing tray model based on the splicing tray information, and then displays the second splicing tray interface and the first splicing tray interface based on the simplified splicing tray model and/or the splicing tray model. In another possible implementation, the server generates the simplified splicing tray model and/or the splicing tray model based on the splicing tray information. The hop confirmation request includes the simplified splicing tray model and/or the splicing tray model, and the terminal does not need to generate the simplified splicing tray model and/or the splicing tray model.

For example, the network management system is run in the server. As shown in FIG. 7, the user provides the splicing tray image for the network management system through the terminal, and the network management system performs image recognition on the splicing tray image to obtain the splicing tray model of the optical cable routing node. The network management system visually displays the splicing tray model through the terminal, and the user selects, for the optical cable path based on the splicing tray model displayed by the terminal, a routing hop that is recorded in the optical cable routing node. Next, a process of recording the routing hop is described with reference to step C3.

C3: In response to a hop confirmation operation on at least one end indicated by the splicing tray model, the terminal sends a hop confirmation response to the server based on the at least one end and a splicing tray to which at least one end option belongs, where the hop confirmation response indicates to confirm the at least one end as the routing hop.

The hop confirmation operation is used to confirm a corresponding end as a routing hop. The hop confirmation operation includes an input hop confirmation operation and an output hop confirmation operation. The input hop confirmation operation and the output hop confirmation operation are respectively used to confirm a selected end as an input routing hop and confirm a selected end as an output routing hop. The hop confirmation response includes hop information of at least one routing hop.

For either of the first splicing tray interface and the second splicing tray interface, the user may perform a hop information recording operation on a model (a splicing tray model or a simplified splicing tray model) in the splicing tray interface, and the terminal displays a hop information recording interface in response to the hop information recording operation. The hop information recording interface is used to record hop information of the optical cable path on the optical cable routing node. The user can record the hop information of the routing hop in the hop information recording interface to specify the routing hop.

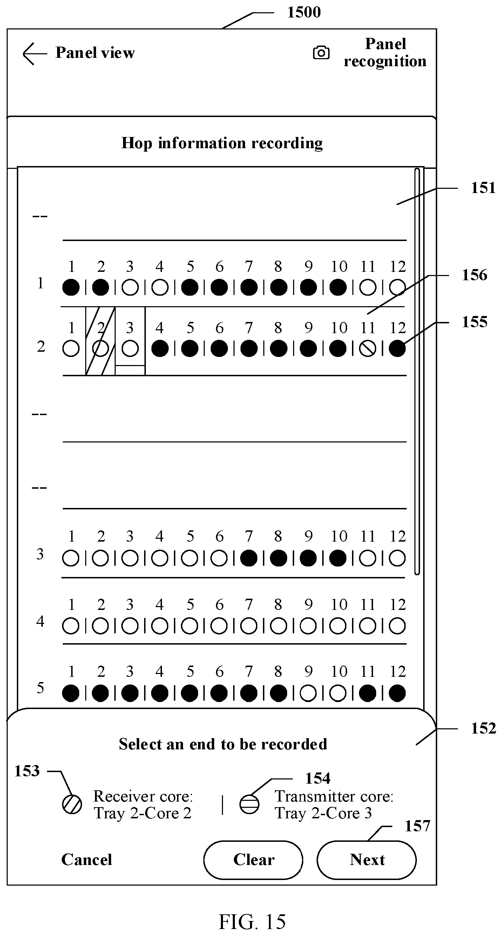

A hop information recording interface 1500 shown in FIG. 15 is used as an example. The hop information recording interface 1500 includes a splicing tray model 151 and an end recording area 152. The end recording area 152 includes an input hop option 153 and an output hop option 154. The input hop option 154 indicates to determine a selected end as an input routing hop, and the output hop option 154 indicates to determine a selected end as an output routing hop.

The user performs a selection operation (for example, a click operation) on the input hop option 153, searches the splicing tray model 151 for an end option 155 (referred to as a first end option) of an input end connected to a first optical fiber, and performs a selection operation (for example, a click operation) on the first end option, to implement an input hop confirmation operation. The first optical fiber is an optical fiber that transmits an optical signal to the optical cable routing node in the optical cable. The optical cable routing node A in FIG. 1 is used as an example, and the first optical fiber is the fiber patch cord 1. The optical cable routing node 1 in FIG. 1 is further used as an example, and the first optical fiber is an optical fiber in the optical cable 1. In response to a selection operation on the input hop option 153 and a first hop option, the terminal confirms an end indicated by the first end option as an input routing hop, confirms a splicing tray indicated by a splicing tray option 156 to which the first end option belongs as a splicing tray (referred to as a first splicing tray) to which the input routing hop belongs, and displays, in the end recording area 152, fiber core position information of the input routing hop. The fiber core position information includes an end identifier of the input routing hop and a splicing tray identifier of the first splicing tray. For example, an end indicated by the 2^{nd} end option 155 of the 2^{nd} splicing tray option 156 in FIG. 15 is confirmed as an input routing hop, the input routing hop is a receiver core, and fiber core position information of the input routing hop is "Tray 2-Core 2", to indicate that the 2^{nd} end in the 2^{nd} splicing tray is the input routing hop.

The user performs a selection operation (for example, a click operation) on the output hop option 154, searches the splicing tray model 151 for an end option 155 (referred to as a second end option) corresponding to an output end connected to a second optical fiber, and performs a selection operation (for example, a click operation) on the second end option, to implement an output hop confirmation operation. The second optical fiber is an optical fiber that receives an optical signal from the optical cable routing node in the optical cable. The optical cable routing node A in FIG. 1 is used as an example, and the second optical fiber is an optical fiber in the fiber patch cord cable 1. The optical cable routing node B in FIG. 1 is further used as an example, and the second optical fiber is the fiber patch cord 2. In response to a selection operation on the output hop option 154 and the second hop option, the terminal confirms an end indicated by the second end option as an output routing hop, confirms a splicing tray indicated by a splicing tray option 156 to which the second end option belongs as a splicing tray (referred to as a second splicing tray) to which the output routing hop belongs, and displays, in the end recording area 152, fiber core position information of the output routing hop. The fiber core position information includes an end identifier of the output routing hop and a splicing tray identifier of the second splicing tray. For example, an end indicated by the 3^{rd} end option 155 of the 2^{nd} splicing tray option 156 in FIG. 15 is confirmed as an output routing hop, the output routing hop is a receiver core, and fiber core position information of the output routing hop is "Tray 2-Core 3", to indicate that the 3^{rd} end in the 2^{nd} splicing tray is the output routing hop.

In a possible implementation, the splicing tray model 151 may not be completely displayed in the terminal. When searching for the first end option or the second end option, the user may slide the splicing tray model 151 in the hop information recording interface by performing a slide operation, to search the splicing tray model 151 for the end option. The slide operation is, for example, sliding the splicing tray model 151 up and down or left and right.

The hop information recording interface 1500 is still used as an example. The hop information recording interface 1500 further includes a "Next" option 157. The "Next" option 157 indicates that recording of the routing hop is completed. After confirming the routing hop of the optical cable path on the optical cable routing node by using the splicing tray model 151, the user performs a selection operation (for example, a click operation) on the "Next" option 157. In response to the selection operation, the terminal generates hop information of the routing hop based on link information of a link to which the optical cable path belongs, cabinet information of a cabinet to which the optical cable path belongs, and fiber core position information of the routing hop, and sends a hop confirmation response to the server. The hop confirmation response includes the hop information.

The splicing tray model supports confirmation of the routing hop. The user can quickly record the hop information of the routing hop by performing an operation on the splicing tray model, meaning that quick recording for the hop information is implemented.

In a possible implementation, as shown in FIG. 6, each time hop information of a routing hop is recorded, the terminal may further display the hop information and longitude and latitude of the routing hop on a routing option 63 corresponding to the routing hop, to prompt the user that the hop has been recorded.

C4: The server receives a hop confirmation response of the terminal, and determines the routing hop based on the hop confirmation response.

For example, the server obtains hop information in the hop confirmation response, and determines an end indicated by each piece of hop information as a routing hop.

In a possible implementation, as shown in FIG. 7, it is assumed that the network management system is run in the server. After the user chooses to record the hop information of the routing hop through the terminal, the network management system notifies, through the terminal, the user that the routing hop is recorded successfully. For example, the following step C5 is performed.

C5: The server sends a hop confirmation success response to the terminal, where the hop confirmation success response indicates that the routing hop of the optical cable path on the optical cable routing node has been confirmed.

After receiving the hop confirmation success response, the terminal displays a confirmation success response in the hop information recording interface, to prompt the user that the routing hop has been confirmed.

The hop information recording interface 1500 is used as an example. In some embodiments, after recording of a routing hop is completed, the terminal and the server further update both display states of the first end option and the second end option in the splicing tray model 151 from a first display state to a second display state. The display state indicates whether the corresponding end has been recorded as the routing hop, the first display state indicates that the corresponding end has been recorded as the routing hop, and the second display state indicates that the corresponding end has not been recorded as the routing hop. For example, an end option 155 filled in black is in the first display state, and an end option 155 not filled in black is in the second display state. Certainly, the first display state and the second display state may alternatively be in other representation forms. The representation forms are not limited herein in embodiments of this application.

In some other embodiments, a display state of at least one end option 155 in the hop information recording interface 1500 is a third display state (for example, an end option with a slash in FIG. 15), to indicate that the corresponding end is faulty, so as to provide a prompt of a faulty end in the optical cable routing node.

Step C5 is an optional step. In some other embodiments, the server may not perform step C5, and correspondingly, the terminal does not receive or display a confirmation success response.

For each optical cable routing node that the optical cable passes through, the server may determine, based on the process shown in step 504, a routing hop on the optical cable routing node that the optical cable passes through, so that the server obtains hop information of a plurality of routing hops of the optical cable. In a possible implementation, for a cabinet model in the equipment room model, a cabinet model that is of an optical cable routing node and into which hop information is recorded is referred to as an edited cabinet model, and a cabinet model that is of an optical cable routing node and into which no hop information is recorded is referred to as an unedited cabinet model. A display state of the edited cabinet model in the equipment room model is a fourth display state, and a display state of the unedited cabinet model in the equipment room model is a fifth display state. The fourth display state is different from the fifth display state. For example, in the equipment room model 900, a cabinet identifier 84 with a black border indicates the fourth display state, and a cabinet identifier 84 without a black border indicates the fifth display state. The fourth display state and the fifth display state are used to prompt the user about cabinets for which routing hops have been recorded and cabinets for which routing hops have not been recorded.

505: The server obtains racking information of each optical cable segment of the optical cable, where the racking information indicates a connection status between the optical cable segment and the optical cable routing node.

The optical cable includes at least one optical cable segment, racking information of any optical cable segment further indicates a connection status between each optical fiber in the optical cable segment and an end in the splicing tray in the optical cable routing node, and the racking information of the optical cable segment includes start racking information and termination racking information of the optical cable segment.

In a possible implementation, a racking information library of the server stores racking information of a plurality of optical cable segments. The server may obtain racking information of each optical cable segment of the optical cable path from the racking information library . The racking information library may be stored locally in the server, or may be stored in a storage device other than the server. A storage position of the racking information library is not limited herein in embodiments of this application.

In another possible implementation, for any optical cable routing node of the optical cable path, the server obtains, from the terminal based on a splicing tray model of the optical cable routing node, racking information of an optical cable segment connected to the optical cable routing node. If the optical cable routing node is a source routing node or a sink routing node on the optical cable path, the optical cable routing node is connected to one optical cable segment, or if the optical cable routing node is an intermediate node on the optical cable path, the optical cable routing node is connected to two optical cable segments. Next, for any optical cable segment connected to the optical cable routing node, the following describes, through the following step D1 to step D2, a process of obtaining racking information of the optical cable segment.

Step D1: For any optical cable segment connected to any optical cable routing node of the optical cable, in response to a connection confirmation operation on at least one end indicated by the splicing tray model of the optical cable routing node, the terminal sends racking information of the optical cable segment to the server based on the at least one end and a splicing tray to which the at least one end belongs.

The optical cable segment is an optical cable segment to which a first optical fiber connected to the optical cable routing node belongs, or is an optical cable segment to which a second optical fiber connected to the optical cable routing node belongs. The connection confirmation operation is used to confirm a corresponding end as an associated end of the optical cable segment. If the optical cable routing node is a start routing node of the optical cable segment on the optical cable path, the associated end is a start end of the optical cable segment. If the optical cable routing node is a termination routing node of the optical cable segment on the optical cable path, the associated end is a termination end of the optical cable segment.

As shown in FIG. 7, it is assumed that the user knows the racking information of the optical cable segment, and the user chooses to rack the optical cable on the terminal based on the splicing tray model, to record the racking information of the optical cable segment. The terminal uploads the racking information recorded by the user to the network management system in the server. For example, for either of the first splicing tray interface and the second splicing tray interface, the user may perform a racking information recording operation on a model (a splicing tray model or a simplified splicing tray model) in the splicing tray interface. The terminal displays the racking information recording interface in response to the racking information recording operation. The racking information recording operation is used to trigger display of the racking information recording interface, and the racking information recording interface is used to record the racking information of the optical cable segment based on the splicing tray model.

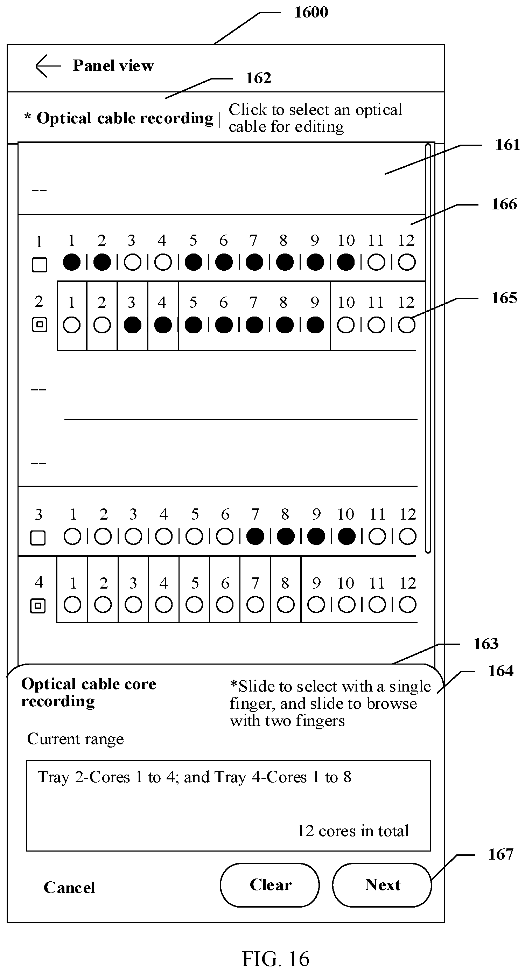

A racking information recording interface 1600 shown in FIG. 16 is used as an example. The racking information recording interface 1600 includes a splicing tray model 161 and an optical cable recording option 162. The optical cable recording option 162 is used to select an optical cable segment for which racking information is to be recorded. The user performs a selection operation (for example, a click operation) on the optical cable recording option 162. The terminal displays an optical cable selection interface in response to the selection operation. The optical cable selection interface includes a plurality of optical cable options, and each optical cable option indicates one optical cable segment. The user performs a selection operation (for example, a click operation) on an optical cable option corresponding to the optical cable segment. In response to the selection operation, the terminal displays an optical cable core recording sub-interface 163 in the racking information recording interface 1600. The optical cable core recording sub-interface 163 indicates to record an associated end of each optical fiber in the optical cable segment.

As shown in FIG. 16, the optical cable core recording sub-interface 163 includes selection prompt information 164, and the selection prompt information 164 is used to provide a prompt indicating an operation manner of selecting an associated end from the splicing tray model 161. The user may search the splicing tray model 161 for a plurality of end options 165 of a plurality of associated ends of the optical cable segment on the optical cable routing node in the operation manner, and perform a selection operation (for example, a click operation) on the plurality of found end options 165. In response to a selection operation on the optical cable option of the optical cable segment and the plurality of end options 165, for any one of the plurality of end options 165, an end indicated by the end option 165 is confirmed as an associated end of the optical cable segment, and a splicing tray indicated by the splicing tray option 166 to which the end option 165 belongs is confirmed as an associated splicing tray to which the associated end belongs. The terminal displays, in the optical cable core recording sub-interface 163, a splicing tray identifier of each associated tray of the optical cable segment and an end identifier of each associated end, for example, "Tray 2-Cores 1 to 4" and "Tray 4-Cores 1 to 8", to indicate that the 1^{st} end to the 4^{th} end in the 2^{nd} splicing tray and the 1^{st} end to the 8^{th} end in the 4^{th} splicing tray in the optical cable routing node are associated ends of the optical cable segment. In a possible implementation, the terminal further displays a quantity (for example, 12 cores) of optical fibers in the optical cable segment in the optical cable core recording sub-interface 163.

After completing selection of an associated end of the optical cable segment on the optical cable routing node, the user may further perform a selection operation on a "Next" option 167 in the optical cable core recording sub-interface 164, and display an end attribute option interface. The end attribute selection interface is used to record an attribute of the associated end. The end attribute selection interface includes an input attribute option and an output attribute option, the input attribute option indicates that the recorded associated end is a termination end of the optical cable segment, and the output attribute option indicates that the recorded associated end is the start end of the optical cable segment. If the optical cable routing node is a start routing node of the optical cable segment, the user performs a selection operation on the output attribute option to complete the connection confirmation operation, and in response to the connection confirmation operation, the terminal generates start racking information of the optical cable segment based on a splicing tray identifier of each associated tray of the optical cable segment in the optical cable routing node, an end identifier of each associated end, an output attribute identifier of the associated end, and cabinet information of the optical cable routing node, and sends the start racking information to the server. The output attribute identifier indicates that the associated end is a start end. If the optical cable routing node is a termination routing node of the optical cable segment, the user performs a selection operation on an input attribute option to complete the connection confirmation operation, and in response to the selection operation, the terminal generates termination racking information of the optical cable segment based on a splicing tray identifier of each associated tray of the optical cable segment in the optical cable routing node, an end identifier of each associated end, an input attribute identifier of the associated end, and cabinet information of the optical cable routing node, and sends the termination racking information to the server.

In a possible implementation, the splicing tray model 161 may not be completely displayed in the terminal. When searching for the end option corresponding to the associated end, the user may slide the splicing tray model 161 in the optical cable core recording sub-interface 1600 by performing a slide operation, to search the splicing tray model 161 for the end option. The slide operation is, for example, sliding the splicing tray model 161 up and down or left and right.

The splicing tray model further supports recording of the racking information. The user can quickly record the racking information of the optical cable segment by operating the splicing tray model, meaning that quick recording for the racking information is implemented.

Step D2: The server receives the racking information that is returned by the terminal based on the splicing tray model.

In some embodiments, as shown in FIG. 7, it is assumed that the network management system is run in the server. After the user selects the recorded racking information of the optical cable segment through the terminal and provides the racking information for the network optical cable management system, the network management system further notifies, through the terminal, the user that a racking operation is successfully performed on the optical cable segment on the optical cable routing node. For example, the following step D3 is performed.

Step D3: The server sends a racking success response to the terminal, where the racking success response indicates that the racking operation is successfully performed on optical cable segment on the optical cable routing node.

After obtaining racking information of any optical cable segment on any optical cable routing node, the server sends a racking success response to the terminal. After receiving the racking success response, the terminal displays the racking success response in an optical cable core recording interface, to prompt the user that a racking operation is successfully performed on the optical cable segment on the optical cable routing node.

On the optical cable path, the optical cable segment is connected to two optical cable routing nodes. The foregoing step D1 to step D3 are described by using an example in which racking information of the optical cable segment on one optical cable routing node is obtained. For a process of obtaining racking information of an optical cable segment on another optical cable routing node, refer to the foregoing step D1 to step D3. After the server obtains the racking information of the optical cable segment on the two optical cable routing nodes, a racking operation is successfully performed on the optical cable segment on the two optical cable routing nodes.

Step 505 is an optional step. In some other embodiments, the server knows the racking information of each optical cable segment on the optical cable path, and the server does not need to obtain the racking information of the optical cable segment by performing step 505.

506: The server models the optical cable path of the optical cable based on routing hops of the optical cable and the racking information of all the optical cable segments of the optical cable, to obtain the digital twin model of the optical cable path.

The digital twin model is used to perform 1:1 digital restoration on a physical topology of the optical cable path, and the digital twin model indicates each optical cable dumb resource that the optical cable passes through, a routing hop of the optical cable on each optical cable routing node, and an optical cable segment connected to each routing hop. Optionally, the digital twin model includes a list of dumb optical line resources, hop information of each routing hop of the optical cable, and racking information of each optical cable segment of the optical cable path. The list of dumb optical line resources indicates an optical cable dumb resource that the optical cable passes through.

In a possible implementation, the server obtains the optical cable path through fitting based on all optical cable routing hops that the optical cable passes through and the racking information of all optical cable segments, and then establishes the digital twin model of the optical cable path based on all the dumb optical line resources that the optical cable path obtained through fitting actually passes through. For example, processes shown in the following step E1 and step E4 are performed.

Step E1: The server determines a reference optical cable path based on the routing hops of the optical cable and the racking information of all the optical cable segments, where the reference optical cable path includes all optical cable routing nodes that the optical cable passes through.

The reference optical cable path indicates an approximate path direction of the optical cable path, and the reference optical cable path is an initial path of the optical cable path.

The server determines, based on the racking information of each optical cable segment of the optical cable and each routing hop of the optical cable, a routing hop count of each optical cable routing node that the optical cable passes through. A routing hop count obtained by any optical cable routing node is a routing hop count of a routing hop of the optical cable on the optical cable routing node, and a routing hop count of a start routing node of any optical cable segment of the optical cable path is less than a routing hop count of a termination routing node of the optical cable segment. For example, the routing hop count of the start routing node is 1 less than the routing hop count of the termination routing node. Alternatively, the server obtains, from each routing option 63 in the path modeling interface of the optical cable, a routing hop count corresponding to the optical cable routing node.

For any optical cable routing node that the optical cable passes through, a routing hop count of the optical cable routing node and position information of the optical cable routing node are used as point/position information of the optical cable routing node, and point/position information of optical cable routing nodes that the optical cable passes through is sorted in ascending order of routing hop counts, to obtain a point/position information list of the optical cable path of the optical cable.

The server performs path planning based on a geographical position of a network element device to which the source of the optical cable belongs, the point/position information list, and a geographical position of a network element device to which the sink of the optical cable belongs, to obtain a reference optical cable path. A start point and a termination point of the reference optical cable path are respectively the network element device on which the source of the optical cable is located and the network element device on which the sink of the optical cable is located, and the optical cable routing node is an intermediate point on the reference optical cable path.

Step E2: The server determines a key point on the optical cable path based on the reference optical cable path.

The key point may be a turning point on the optical cable path. In a possible implementation, the server requests the terminal to determine a key point on the optical cable path based on the reference optical cable path. For example, processes shown in the following step E21 to step E23 are performed.

E21: The server sends a key point obtaining request to the terminal based on the reference optical cable path, where the key point obtaining request indicates to obtain the key point on the optical cable path based on the reference optical cable path.

The key point obtaining request includes path information of the reference optical cable path. The path information indicates the reference optical cable path.

E22: The terminal returns a key point obtaining response to the server based on the key point obtaining request, where the key point obtaining response indicates the key point on the optical cable path.

The key point obtaining response includes position information of at least one key point on the optical cable path.

After receiving the key point obtaining request, the terminal parses the key point obtaining request to obtain the path information of the reference optical cable path, and displays a key point confirmation interface based on the path information. The reference optical cable path is displayed in the key point confirmation interface, and the key point confirmation interface indicates to confirm the key point on the optical cable path based on the reference optical cable path.

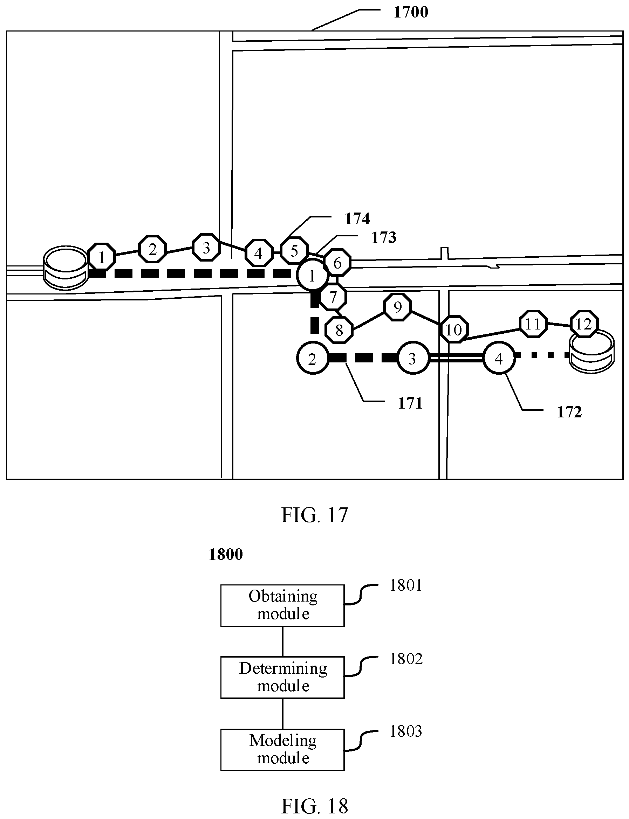

In a possible implementation, the key point confirmation interface includes an electronic map, and the reference optical cable path is displayed on the electronic map. For example, a reference optical cable path 171 is displayed on an electronic map 1700 shown in FIG. 17. The user pinpoints and marks key points on the optical cable path on the map 1700 by using a direction of the reference optical cable path as the reference direction of the optical cable path.

FIG. 17 is used as an example. It is assumed that a key point is a turning point. An optical cable on an optical cable path is routed along a road from an equipment room to which a source belongs, and is bent and continues to be laid at an intersection, so that the optical cable forms a turning point at the intersection until the optical cable is laid to an equipment room to which a sink belongs. The user uses at least one turning point on the optical cable path as a key point, and from a start point of a reference path 171, pinpoints and marks the at least one key point on the electronic map 1700 along the reference optical cable path 171, for example, clicks the position of the key point on the electronic map 1700. In response to a pinpointing and marking operation on any position, the terminal displays a key point mark 172 at this position. The key point mark 172 indicates that the position is a key point on the optical cable path. For any key point, the key point may be located on the reference optical cable path, or may not be located on the reference optical cable path.

When the user marks each key point on the optical cable path on the map 1700, the terminal determines a position of the key point mark 172 as a key point, and sends a key point obtaining response to the server based on each determined key point. For example, the terminal generates a key point list based on a position of each key point mark, generates a key point obtaining response based on the key point list, and sends the key point obtaining response to the server. The key point list includes position information (for example, longitude and latitude) of a position of each key point mark.

E23: The server receives the key point obtaining response, and determines each key point on the optical cable path based on the key point obtaining response.

The server parses the key point obtaining response to obtain the key point list, and determines a position indicated by each piece of position information in the key point list as a key point.

Step E3: The server performs path fitting based on the reference optical cable path and the key point on the optical cable path, to obtain a list of dumb optical line resources of the optical cable path, where the list of dumb optical line resources indicates each dumb optical line resource that the optical cable path passes through.

Each dumb optical line resource that the optical cable path passes through is an optical cable routing node or a non-optical cable routing node, and the optical cable path passes through the foregoing key point. The list of dumb optical line resources includes point/position information of each dumb optical line resource that the optical cable path passes through. Point position information of any dumb optical line resource indicates a geographical position of the dumb optical line resource and a position of the dumb optical line resource on the optical cable path. For example, the point/position information includes longitude and latitude of the dumb optical line resource, to indicate the geographical position. The point/position information includes a sequence number of the dumb optical line resource, and the sequence number indicates the position of the dumb optical line resource on the optical cable path. For example, a sequence number of the 1^{st} dumb optical line resource that the optical cable path passes through is 1, a sequence number of the 2^{nd} dumb optical line resource that the optical cable path passes through is 2, and so on.

In a possible implementation, the server performs path fitting on a dumb optical line resource around the reference optical cable path, the reference optical cable path, and the key point on the optical cable path by using a Dijkstra (Dijkstra) path restoration algorithm and a shortest relative distance rule, to obtain the list of dumb optical line resources.

For example, the server determines a plurality of candidate dumb optical line resources based on the reference optical cable path. A distance between each candidate dumb optical line resource and the reference optical cable path is less than or equal to a distance threshold, and the distance threshold is greater than or equal to 0. For a start point of the reference optical cable path, a termination point of the reference optical cable path, each optical cable routing node, and any two adjacent points in key points, a shortest path between the two points is determined based on the Dijkstra path restoration algorithm, geographical positions of the two points, and geographical positions of the plurality of candidate dumb optical line resources. A path including the start point of the reference optical cable path, the termination point of the reference optical cable path, each optical cable routing node, and a shortest path between any two adjacent points in the key points is determined as the optical cable path. Each candidate dumb optical line resource, each key point, and each optical cable routing node on the optical cable path are dumb optical line resources that the optical cable passes through. The dumb optical line resources that the optical cable path passes through are sorted in an order from the start point to the termination point of the optical cable path, to obtain a sequence number of each dumb optical line resource that the optical cable passes through. The list of dumb optical line resources is generated based on the sequence number of each dumb optical line resource that the optical cable passes through and a geographical position of the dumb optical line resource.

In a possible implementation, the server further displays the optical cable path on the terminal based on the list of optical cable dumb resources, to prompt the user that fitting of the optical cable path is completed. As shown in FIG. 7, the user submits, to the network management system in the server, a key point that is of the optical cable path and that is marked by the terminal. The network management system fits, by using a path restoration technology and based on the key point marked by the user, a list of infrastructures (that is, the list of optical cable dumb resources) that the optical cable passes through, and sends a path fitting success response to the terminal based on the list of infrastructures, where the path fitting success response indicates that fitting of the optical cable path of the optical cable is completed. The terminal uses the list of infrastructures in the path fitting success response as path information of the optical cable path, and displays the optical cable path on the electronic map in the key point confirmation interface, for example, an optical cable path 173 on the electronic map 1700. The optical cable path 173 includes a plurality of dumb optical line resources 174.

Step E4: The server generates the digital twin model based on the list of dumb optical line resources, each routing hop of the optical cable path, and the racking information of each optical cable segment of the optical cable path.

The server determines a routing link of the optical cable based on the hop information of each routing hop of the optical cable path and the racking information of each optical cable segment of the optical cable path. The routing link indicates a routing status of an optical signal in the optical cable between a source and a sink, and the routing link includes each routing hop of the optical cable path and an optical cable segment connected to the routing hop.

For example, the server uses a routing hop connected to the source as a first hop (that is, the 1^{st} routing hop) of a routing link, and matches hop information of the first hop with start racking information of each optical cable segment of the optical cable path. If a start end indicated by start racking information of any optical cable segment is an output routing hop indicated by the hop information, the hop information matches the start racking information. The server determines the optical cable segment as an optical cable segment connected to the first hop in a direction toward the sink, and the server matches termination racking information of the optical cable segment connected to the first hop with hop information of a remaining hop. If an input routing hop indicated by hop information of any remaining hop is a termination end indicated by the termination racking information, the termination racking information matches the hop information of the remaining hop. The server confirms the remaining hop as a second hop (that is, the 2^{nd} routing hop) of the routing link. Then the server matches hop information of the second hop with start racking information of a remaining optical cable segment, to determine an optical cable segment connected to the second hop in the direction toward the sink. The rest is deduced by analogy, until a last hop (that is, a last routing hop) of the routing link is determined.

The server determines a link including the first hop, the optical cable segment connected to the first hop in the direction toward the sink, the second hop, the optical cable segment connected to the second hop in the direction toward the sink, ..., and the last hop as the routing link. For any hop after the first hop, an optical cable segment connected to a previous hop of the hop in the direction toward the sink is an optical cable segment connected to the hop in a direction toward a source. The server combines, in a sequence of each routing hop in the routing link and an optical cable segment connected to the routing hop, hop information of the first hop, racking information of the optical cable segment connected to the first hop in the direction toward the sink, hop information of the second hop, hop information of the optical cable segment connected to the second hop in the direction toward the sink, ..., and information about the last hop, to obtain routing information of the routing link.

The server uses the routing information and the list of dumb optical line resources as physical routing information of the optical cable path, and uses the physical routing information as the digital twin model of the optical cable path. Routing information in the digital twin model can reflect the routing link of the optical cable path, and the list of dumb optical line resources can reflect the optical cable dumb resource that the optical cable path actually passes through, so that the digital twin model can describe a routing status of the optical cable path and the optical cable dumb resource that the optical cable path actually passes through, to perform 1:1 digital restoration on the optical cable path.

507: The server sends the digital twin model to the terminal.

508: The terminal receives the digital twin model.

After receiving the digital twin model, the terminal may also display the digital twin model. Step 507 and step 508 are optional steps. The server may not send the digital twin model to the terminal. In this case, the terminal does not need to receive or display the digital twin model. A procedure of the model establishment method for an optical cable path may include the steps performed by the server in FIG. 5, and a procedure of a model obtaining method for an optical cable path may include the steps performed by the client in FIG. 5.

In the method embodiment shown in FIG. 5, a routing hop of an optical cable on each optical cable routing node that the optical cable passes through can be determined based on a splicing tray image of the optical cable routing node; and a digital twin model of an optical cable path of the optical cable is established based on each routing hop of the optical cable and a connection status between each optical cable segment and the optical cable routing node, to perform 1:1 digital restoration on a physical topology of the optical cable path by using the digital twin model, so that digital management is subsequently performed on dumb optical line resources on the optical cable path by using the digital twin model.

The foregoing is described by using an example in which the server completes the modeling method for an optical cable path by interacting with the terminal. In another possible implementation, the server or the terminal may independently complete the modeling method for an optical cable path.

The foregoing describes the methods in embodiments of this application, and the following describes apparatuses in embodiments of this application. It should be understood that the apparatus described below has any function of the server or the terminal in the foregoing methods. With reference to FIG. 5 to FIG. 17, the foregoing describes in detail the model establishment method for an optical cable path and the model obtaining method for an optical cable path according to embodiments of this application. Based on the same inventive concept, the following describes an apparatus and a device in this application with reference to FIG. 18 to FIG. 20. It should be understood that the technical features described in the method embodiments are also applied to the following apparatus embodiments.

Refer to FIG. 18. An embodiment of this application provides a model establishment apparatus for an optical cable path. As shown in FIG. 18, the apparatus 1800 includes:
an obtaining module 1801, configured to obtain a splicing tray image of each optical cable routing node that an optical cable passes through, where the splicing tray image is used to present a splicing tray in the optical cable routing node and an end in the splicing tray;
a determining module 1802, configured to: for any optical cable routing node, determine, based on the splicing tray image of the optical cable routing node, a routing hop of the optical cable on the optical cable routing node from the end in the splicing tray; and
a modeling module 1803, configured to model an optical cable path of the optical cable based on routing hops of the optical cable and racking information of all optical cable segments of the optical cable, to obtain a digital twin model of the optical cable path, where the racking information indicates a connection status between the optical cable segments and the optical cable routing node.

In a possible implementation, the determining module 1802 includes:
an establishment unit, configured to establish, based on the splicing tray image, a splicing tray model of the optical cable routing node, where the splicing tray model includes at least one splicing tray option and an end option corresponding to the splicing tray option; and
a determining unit, configured to determine, based on the splicing tray model, a routing hop of the optical cable on the optical cable routing node.

In a possible implementation, the determining unit is configured to:
send a hop confirmation request to a terminal based on the splicing tray model, where the hop confirmation request indicates to confirm the routing hop based on the splicing tray model;
receive a hop confirmation response of the terminal, where the hop confirmation response indicates to confirm at least one end as the routing hop; and
determine the routing hop based on the hop confirmation response.

In a possible implementation, the obtaining module 1801 is further configured to:
receive the racking information that is returned by the terminal based on the splicing tray model.

In a possible implementation, the modeling module 1803 is configured to:
determine a reference optical cable path based on the routing hops of the optical cable and the racking information of all the optical cable segments of the optical cable, where the reference optical cable path includes all optical cable routing nodes that the optical cable passes through;
perform path fitting based on the reference optical cable path and a key point on the optical cable path, to obtain a list of dumb optical line resources of the optical cable path, where the dumb optical line resource indicates a dumb optical line resource that the optical cable passes through; and
generate the digital twin model based on the list of dumb optical line resources, each routing hop of the optical cable, and the racking information of each optical cable segment of the optical cable.

The apparatus 1800 corresponds to the server in the foregoing method embodiments, and the modules in the apparatus 1800 and the foregoing other operations and/or functions are respectively for implementing steps and methods implemented by the server in the method embodiments. For specific details, refer to the foregoing method embodiments. For brevity, details are not described herein again.

When the apparatus 1800 establishes the digital twin model of the optical cable path, division into the foregoing functional modules is merely an example for description. During actual application, the foregoing functions may be allocated to different functional modules for implementation according to a requirement. In other words, an internal structure of the apparatus 1800 is divided into different functional modules to complete all or a part of the functions described above. In addition, the apparatus 1800 provided in the foregoing embodiment and the foregoing method embodiment belong to a same concept. For a specific implementation process thereof, refer to the foregoing method embodiment. Details are not described herein again.

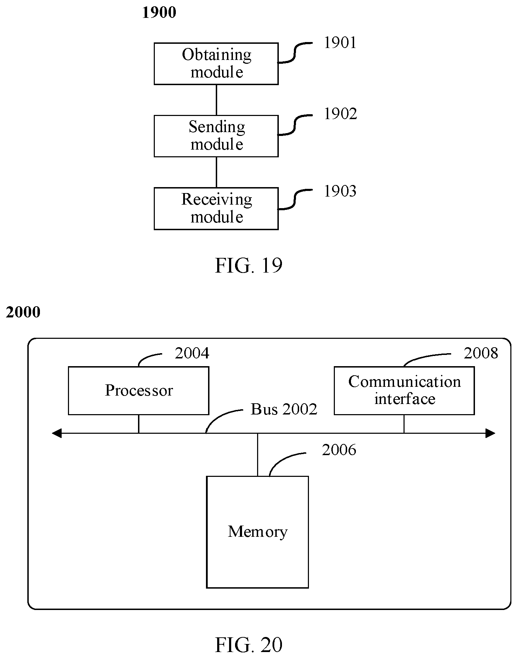

Refer to FIG. 19. An embodiment of this application provides a model obtaining apparatus for an optical cable path. As shown in FIG. 19, the apparatus 1900 includes:
an obtaining module 1901, configured to obtain a splicing tray image of an optical cable routing node that an optical cable passes through, where the splicing tray image is used to present a splicing tray in the optical cable routing node and an end in the splicing tray;
a sending module 1902, configured to send the splicing tray image to a server; and
a receiving module 1903, configured to receive a digital twin model of an optical cable path of the optical cable, where the digital twin model is established based on the splicing tray image.

In a possible implementation, the apparatus 1900 further includes:
a first display module, configured to display a splicing tray model of the optical cable routing node, where the splicing tray model indicates each splicing tray in the optical cable routing node and each end in the splicing tray; and
the sending module 1902 is further configured to: in response to the hop confirmation operation on at least one end indicated by the splicing tray model, send a hop confirmation response to the server based on the at least one end and the splicing tray to which at least one end option belongs, where the hop confirmation response indicates to confirm the at least one end as a routing hop.

In a possible implementation, the sending module 1902 is further configured to:
for an optical cable segment connected to the optical cable routing node in the optical cable, in response to a connection confirmation operation on the at least one end, send racking information of the optical cable segment to the server based on the at least one end and the splicing tray to which the at least one end belongs, where the racking information indicates a connection status between the optical cable segment and the optical cable routing node, and the connection confirmation operation is used to confirm that an optical fiber in the optical cable segment is connected to a corresponding end.

In a possible implementation, the apparatus further includes:
a second display module, configured to display an equipment room model template, where the equipment room model template includes a plurality of cabinet areas, and the cabinet area is used to present one cabinet in an equipment room to which the optical cable routing node belongs; and
an adding module, configured to: in response to a cabinet adding operation on any cabinet area, add a cabinet identifier to the cabinet area, to obtain an equipment room model of the equipment room, where the cabinet identifier indicates a cabinet at a position corresponding to the cabinet area in the equipment room.

The apparatus 1900 corresponds to the terminal in the foregoing method embodiments, and the modules in the apparatus 1900 and the foregoing other operations and/or functions are respectively for implementing steps and methods implemented by the terminal in the method embodiments. For specific details, refer to the foregoing method embodiments. For brevity, details are not described herein again.

When the apparatus 1900 obtains the digital twin model of the optical cable path, division into the foregoing functional modules is merely used as an example for description. During actual application, the foregoing functions may be allocated to different functional modules for implementation according to a requirement. In other words, an internal structure of the apparatus 1900 is divided into different functional modules to complete all or a part of the functions described above. In addition, the apparatus 1900 provided in the foregoing embodiment and the foregoing method embodiment belong to a same concept. For a specific implementation process thereof, refer to the foregoing method embodiment. Details are not described herein again.

FIG. 20 is a diagram of a structure of a computing device according to this application. As shown in FIG. 20, the computing device 2000 includes a bus 2002, a processor 2004, a memory 2006, and a communication interface 2008. The processor 2004, the memory 2006, and the communication interface 2008 communicate with each other through the bus 2002. The bus 2002 may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, only one line is used in FIG. 20 for representation, but it does not mean that there is only one bus or one type of bus. The bus 2002 may include a path for transferring information between various components (for example, the memory 2006, the processor 2004, and the communication interface 2008) of the computing device 2000. The processor 2004 may include any one or more of processors such as a central processing unit (central processing unit, CPU), a graphics processing unit (graphics processing unit, GPU), a microprocessor (microprocessor, MP), and a digital signal processor (digital signal processor, DSP). The memory 2006 may be used as an internal memory or an external memory of the computing device 2000. The memory 2006 may include a volatile memory (volatile memory), for example, a random access memory (random access memory, RAM). The memory 2006 may further include a non-volatile memory (non-volatile memory), for example, a read-only memory (read-only memory, ROM), a flash memory, a hard disk drive (hard disk drive, HDD), or a solid state drive (solid state drive, SSD).

The memory 2006 stores executable program code, and the processor 2004 reads and executes the executable program code, to enable the computing device 2000 to implement the model establishment method for an optical cable path and/or the model obtaining method for an optical cable path.

In an example embodiment, a computer-readable storage medium, for example, a memory including program code, is further provided. The program code may be executed by a processor in a computing device to complete the model establishment method for an optical cable path and/or the model obtaining method for an optical cable path in the foregoing embodiments. For example, the computer-readable storage medium is a non-transitory computer-readable storage medium, for example, a ROM, a RAM, a compact disc read-only memory (compact disc read-only memory, CD-ROM), a magnetic tape, a floppy disk, or an optical data storage device.

An embodiment of this application further provides a computer program product or a computer program. The computer program product or the computer program includes program code. Computer instructions are stored in a computer-readable storage medium. A processor of a computing device reads the program code from the computer-readable storage medium. The processor executes the program code, to enable the computing device to perform the model establishment method for an optical cable path and/or the model obtaining method for an optical cable path.

In addition, an embodiment of this application further provides an apparatus. The apparatus may be specifically a chip, a component, or a module. The apparatus may include a processor and a memory that are connected to each other. The memory is configured to store computer-executable instructions. When the apparatus is run, the processor may execute the computer-executable instructions stored in the memory, to enable the apparatus to perform the model establishment method for an optical cable path and/or the model obtaining method for an optical cable path in the foregoing method embodiments.

The apparatus, the device, the computer-readable storage medium, the computer program product, and the chip provided in embodiments are all configured to perform the corresponding methods provided above. Therefore, for beneficial effects that can be achieved, refer to the beneficial effects of the corresponding methods provided above. Details are not described herein again.

In the several embodiments provided in this application, it should be understood that the disclosed apparatus and method may be implemented in other manners. For example, the described apparatus embodiment is merely an example. For example, the module or unit division is merely logical function division and may be other division in an actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or the units may be implemented in electronic, mechanical, or other forms.

The units described as separate parts may or may not be physically separate, and parts displayed as units may be one or more physical units, may be located in one place, or may be distributed on different places. A part or all of the units may be selected based on actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in a form of a software functional unit and sold or used as an independent product, the integrated unit may be stored in a readable storage medium. Based on such an understanding, the technical solutions of embodiments of this application essentially, or the part contributing to the conventional technology, or all or a part of the technical solutions may be implemented in a form of a software product. The software product is stored in a storage medium and includes several instructions for instructing a device (which may be a single-chip microcomputer, a chip, or the like) or a processor (processor) to perform all or a part of the steps of the methods described in embodiments of this application. The foregoing storage medium includes any medium that can store program code, such as a USB flash drive, a removable hard disk, a ROM, a RAM, a magnetic disk, or an optical disc.

In descriptions of this application, unless otherwise specified, "/" means "or". For example, A/B may indicate A or B. The term "and/or" in this specification describes only an association relationship between associated objects and indicates that there may be three relationships. For example, A and/or B may represent the following three cases: Only A exists, both A and B exist, and only B exists. In addition, "at least one" means one or more, and "a plurality of" means two or more. Terms such as "first" and "second" do not limit a quantity and an execution sequence, and the terms such as "first" and "second" do not indicate a definite difference.

In this application, the word "example" or "for example" is used to represent giving an example, an illustration, or a description. Any embodiment or design scheme described as an "example" or "for example" in this application should not be interpreted as being preferred or having more advantages than another embodiment or design scheme. To be precise, use of the word such as "example" or "for example" is intended to present a relative concept in a specific manner.

It should be noted that information (including but not limited to user equipment information, personal information of a user, and the like), data (including but not limited to data used for analysis, stored data, presented data, and the like), and signals in this application are used under authorization by the user or full authorization by all parties, and collection, use, and processing of related data need to conform to related laws, regulations, and standards of related countries and regions. For example, the splicing tray image in this application is obtained with sufficient authorization.

All of the foregoing optional technical solutions may form optional embodiments of this disclosure by using any combination. Details are not described herein again.

The foregoing descriptions are merely optional embodiments of this application, but are not intended to limit this application. Any modification, equivalent replacement, or improvement made without departing from the spirit and principle of this application should fall within the protection scope of this application.

## Claims

1. A model establishment method for an optical cable path, wherein the method comprises:
obtaining a splicing tray image of each optical cable routing node that an optical cable passes through, wherein the splicing tray image is used to present a splicing tray in the optical cable routing node and an end in the splicing tray;
for any optical cable routing node, determining, based on the splicing tray image of the optical cable routing node, a routing hop of the optical cable on the optical cable routing node from the end in the splicing tray; and
modeling an optical cable path of the optical cable based on routing hops of the optical cable and racking information of all optical cable segments of the optical cable, to obtain a digital twin model of the optical cable path, wherein the racking information indicates a connection status between the optical cable segments and the optical cable routing node.

2. The method according to claim 1, wherein the determining, based on the splicing tray image of the optical cable routing node, the routing hop of the optical cable on the optical cable routing node from the end in the splicing tray comprises:
establishing a splicing tray model of the optical cable routing node based on the splicing tray image, wherein the splicing tray model indicates each splicing tray in the optical cable routing node and each end in the splicing tray; and
determining, based on the splicing tray model, the routing hop of the optical cable on the optical cable routing node.

3. The method according to claim 2, wherein the determining, based on the splicing tray model, the routing hop of the optical cable on the optical cable routing node comprises:
sending a hop confirmation request to a terminal based on the splicing tray model, wherein the hop confirmation request indicates to confirm the routing hop based on the splicing tray model;
receiving a hop confirmation response of the terminal, wherein the hop confirmation response indicates to confirm at least one end as the routing hop; and
determining the routing hop based on the hop confirmation response.

4. The method according to claim 3, wherein after the sending the hop confirmation request to the terminal, the method further comprises:
receiving the racking information that is returned by the terminal based on the splicing tray model.

5. The method according to any one of claims 1 to 4, wherein the modeling the optical cable path of the optical cable based on each routing hop of the optical cable and the racking information of each optical cable segment of the optical cable, to obtain the digital twin model of the optical cable path comprises:
determining a reference optical cable path based on the routing hops of the optical cable and the racking information of all the optical cable segments of the optical cable, wherein the reference optical cable path comprises all optical cable routing nodes that the optical cable passes through;
performing path fitting based on the reference optical cable path and a key point on the optical cable path, to obtain a list of dumb optical line resources of the optical cable path, wherein the dumb optical line resource indicates a dumb optical line resource that the optical cable passes through; and
generating the digital twin model based on the list of dumb optical line resources, each routing hop of the optical cable, and the racking information of each optical cable segment of the optical cable.

6. A model obtaining method for an optical cable path, wherein the method comprises:
obtaining a splicing tray image of an optical cable routing node that an optical cable passes through, wherein the splicing tray image is used to present a splicing tray in the optical cable routing node and an end in the splicing tray;
sending the splicing tray image to a server; and
receiving a digital twin model of an optical cable path of the optical cable, wherein the digital twin model is established based on the splicing tray image.

7. The method according to claim 6, wherein after the sending the splicing tray image to the server, the method further comprises:
displaying a splicing tray model of the optical cable routing node, wherein the splicing tray model indicates each splicing tray in the optical cable routing node and each end in the splicing tray; and
in response to a hop confirmation operation on at least one end indicated by the splicing tray model, sending a hop confirmation response to the server based on the at least one end and a splicing tray to which the at least one end belongs, wherein the hop confirmation response indicates to confirm the at least one end as a routing hop.

8. The method according to claim 7, wherein after the displaying the splicing tray model of the optical cable routing node, the method comprises:
for an optical cable segment connected to the optical cable routing node in the optical cable, in response to a connection confirmation operation on the at least one end, sending racking information of the optical cable segment to the server based on the at least one end and the splicing tray to which the at least one end belongs, wherein the racking information indicates a connection status between the optical cable segment and the optical cable routing node, and the connection confirmation operation is used to confirm that an optical fiber in the optical cable segment is connected to a corresponding end.

9. The method according to any one of claims 6 to 8, wherein before the obtaining the splicing tray image of the optical cable routing node that the optical cable passes through, the method further comprises:
displaying an equipment room model template, wherein the equipment room model template comprises a plurality of cabinet areas, and the cabinet area is used to present one cabinet in an equipment room to which the optical cable routing node belongs; and
in response to a cabinet adding operation on any cabinet area, adding a cabinet identifier to the cabinet area, to obtain an equipment room model of the equipment room, wherein the cabinet identifier indicates a cabinet at a position corresponding to the cabinet area in the equipment room.

10. A model establishment apparatus for an optical cable path, wherein the apparatus comprises:
an obtaining module, configured to obtain a splicing tray image of each optical cable routing node that an optical cable passes through, wherein the splicing tray image is used to present a splicing tray in the optical cable routing node and an end in the splicing tray;
a determining module, configured to: for any optical cable routing node, determine, based on the splicing tray image of the optical cable routing node, a routing hop of the optical cable on the optical cable routing node from the end in the splicing tray; and
a modeling module, configured to model an optical cable path of the optical cable based on routing hops of the optical cable and racking information of all optical cable segments of the optical cable, to obtain a digital twin model of the optical cable path, wherein the racking information indicates a connection status between the optical cable segments and the optical cable routing node.

11. A model obtaining apparatus for an optical cable path, wherein the apparatus comprises:
an obtaining module, configured to obtain a splicing tray image of an optical cable routing node that an optical cable passes through, wherein the splicing tray image is used to present a splicing tray in the optical cable routing node and an end in the splicing tray;
a sending module, configured to send the splicing tray image to a server; and
a receiving module, configured to receive a digital twin model of an optical cable path of the optical cable, wherein the digital twin model is established based on the splicing tray image.

12. A computing device, wherein the computing device comprises a processor, and the processor is configured to execute program code, to enable the computing device to perform the method according to any one of claims 1 to 9.

13. A computer-readable storage medium, wherein the storage medium stores at least one piece of program code, and the at least one piece of program code is read by a processor, to enable a computing device to perform the method according to any one of claims 1 to 9.
